# EUROPEAN PATENT APPLICATION

(11) **EP 4 582 871 A1**
(43) Date of publication of application: **09.07.2025**
(21) Application number: 24807409.8
(22) Date of filing: 03.05.2024
(51) Int. Cl.: G03F 7/004, G03F 7/038, G03F 7/075, C08G 73/10

(54) **PHOTOSENSITIVE RESIN COMPOSITION, INSULATING FILM, AND SEMICONDUCTOR DEVICE**

(30) Priority: 12.05.2023 KR 20230061852
(71) Applicant: LG CHEM, LTD., Seoul 07336 (KR)
(72) Inventor: KIM, Ji Hye, Daejeon 34122 (KR); SUNG, Ji Yeon, Daejeon 34122 (KR); PARK, Hyun Min, Daejeon 34122 (KR); JEON, Seong Ho, Daejeon 34122 (KR); LIM, Min Young, Daejeon 34122 (KR)
(74) Representative: Goddar, Heinz J.
(86) International application number: PCT/KR2024/006000
(87) International publication number: WO 2024/237532

(57) **Abstract**

The present disclosure relates to a photosensitive resin composition, and provides a photosensitive resin composition soluble in an environmental-friendly aqueous solvent, developable with an aqueous developing solution, and capable of providing an insulating film with excellent chemical resistance, low dielectric constant characteristics, low dielectric loss characteristics and mechanical properties.

## Description

### Technical Field

The present disclosure relates to a photosensitive resin composition, an insulating film and a semiconductor device.

This application is a National Stage Application of International Application No. PCT/KR2024/006000 filed on May 3, 2024, which claims priority to and the benefits of Korean Patent Application No. 10-2023-0061852, filed with the Korean Intellectual Property Office on May 12, 2023, the entire contents of which are incorporated herein by reference.

### Background Art

For a surface protective film, an interlayer insulating film or the like of a semiconductor element of an electronic device, a polyimide-based resin, a polybenzoxazole-based resin and the like having excellent heat resistance, mechanical properties or the like have been widely used in the art. When forming a thin film including these resins, high temperature heating treatment at around 350°C is usually required when a thin film having excellent heat resistance and mechanical properties is obtained by thermally dehydrating and ring-closing a coating film of a polyimide precursor or a polybenzoxazole precursor.

However, in response to recent demands such as heat load reduction or low flexure for devices, a polyimide-based resin or a polybenzoxazole-based resin curable by heating treatment at a low temperature of about 250°C or lower and more preferably 200°C or lower has been required.

### DISCLOSURE

### Technical Problem

The present disclosure is directed to providing a photosensitive resin composition soluble in an environmental-friendly aqueous solvent, developable with an aqueous developing solution, and capable of providing an insulating film with excellent chemical resistance, low dielectric constant characteristics, low dielectric loss characteristics and mechanical properties.

However, objects to be addressed by the present disclosure are not limited to the object mentioned above, and other objects not mentioned will be clearly appreciated by those skilled in the art from the following description.

### Technical Solution

One embodiment of the present disclosure provides a photosensitive resin composition including a polyimide including repeating units represented by the following Chemical Formulae 1 to 4, wherein a ratio between the total number of -F functional groups and the total number of -OH functional groups included in the repeating units represented by Chemical Formulae 1 to 4 satisfies 2≤-F/-OH≤5: 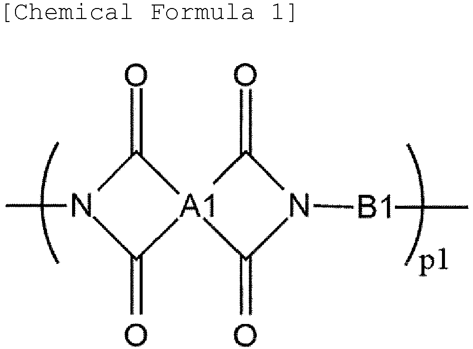 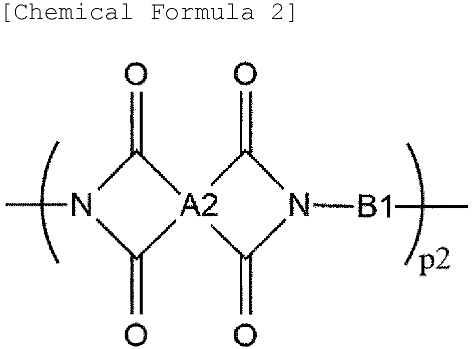 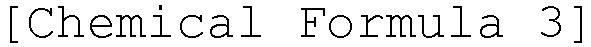 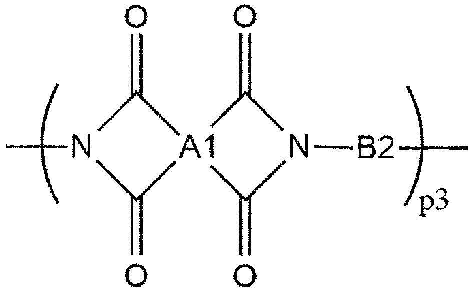 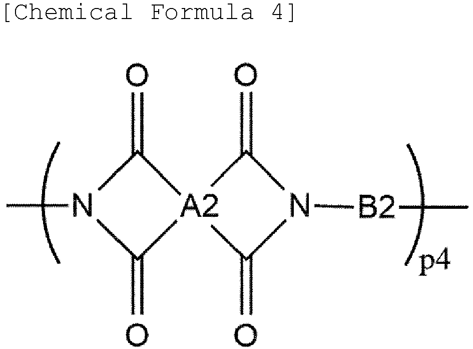 wherein in Chemical Formulae 1 to 4,
A1 is a tetravalent aliphatic organic group; A2 is a tetravalent aromatic ring group; B1 is a divalent aromatic ring group; B2 is a flexible functional group; p1 to p4 are each independently an integer of 1 to 10,000; and at least one of A1, A2, B1 and B2 includes -F, -OH or -F and -OH functional groups.

In addition, another embodiment of the present application provides an insulating film including the photosensitive resin composition or a cured product thereof.

In addition, another embodiment of the present application provides a semiconductor device including the insulating film.

### Advantageous Effects

A photosensitive resin composition according to one embodiment of the present disclosure includes a polyimide including repeating units represented by Chemical Formulae 1 to 4, and since a ratio between the total number of -F functional groups and the total number of -OH functional groups included in the repeating units represented by Chemical Formulae 1 to 4 satisfies 2≤-F/-OH≤5, the composition has advantages of being readily soluble in propylene glycol monomethyl ether acetate (PGMEA), an environmental-friendly aqueous solvent, and the like, and developable with TMAH (tetramethylammonium hydroxide), an aqueous developing solution, and the like.

Specifically, -F and -OH functional groups are required in order for the photosensitive resin composition to be readily soluble in PGMEA, an environmental-friendly aqueous solvent, and developable with TMAH, an aqueous developing solution, however, as the -F and -OH functional groups increase, there are disadvantages in that properties such as dielectric loss (Df) and elongation become poor, and chemical resistance becomes poor as well.

However, the photosensitive resin composition according to one embodiment of the present disclosure includes a polyimide including the repeating units represented by Chemical Formulae 1 to 4, and since a ratio between the total number of -F functional groups and the total number of -OH functional groups included in the repeating units represented by Chemical Formulae 1 to 4 satisfies 2≤-F/-OH≤5, the composition has advantages of being readily soluble in PGMEA, an environmental-friendly aqueous solvent, and developable with TMAH, an aqueous developing solution, and an insulating film with excellent low dielectric constant characteristics, low dielectric loss characteristics, mechanical properties such as elongation, and chemical resistance can be provided.

Effects of the present disclosure are not limited to the above-described effects, and effects not mentioned will be clearly appreciated by those skilled in the art from the present specification and accompanying drawings.

### Mode for Invention

In the present specification, a description of a certain part "including" certain constituents means that it may further include other constituents, and does not exclude other constituents unless particularly stated on the contrary.

Throughout the present specification, a description of a certain member being placed "on" another member includes not only a case of the certain member being in contact with the another member but a case of still another member being present between the two members.

Throughout the present specification, a unit "parts by weight" may mean a ratio of weight between each component.

In the present specification, a term including ordinal numbers such as "first" and "second" is used for the purpose of distinguishing one constituent from another constituent, and is not limited by the ordinal numbers. For example, within the scope of a right of the present disclosure, a first constituent may also be referred to as a second constituent, and similarly, a second constituent may be referred to as a first constituent.

Throughout the present specification, a unit "parts by mole" may mean a ratio of mole between each component.

Throughout the present specification, "(meth)acrylate" is used to collectively mean acrylate and methacrylate.

In the present specification, a "polymer" means a compound formed by repeating a repeating unit (basic unit). The polymer may be expressed as a polymer or a compound formed with a polymer.

Throughout the present specification, a "weight average molecular weight" and a "number average molecular weight" of a certain compound may be calculated using molecular weight and molecular weight distribution of the compound. Specifically, tetrahydrofuran (THF) and a compound are introduced to a 1 ml glass vial to prepare a sample having a compound concentration of 1 wt%, and after filtering a standard (polystyrene) and the sample through a filter (pore size of 0.45 µm), they are injected into a GPC injector, and the elution time of the sample may be compared with a calibration curve of the standard to obtain molecular weight and molecular weight distribution of the compound. Herein, Infinity II 1260 (Agilent) may be used as a measuring device, and the flow rate may be set to 1.00 mL/min, and the column temperature may be set to 40.0°C.

Throughout the present specification, a term "substitution" means that another functional group bonds in place of a hydrogen atom in a compound, and the position of substitution is not limited as long as it is a position at which the hydrogen atom is substituted, that is, a position at which a substituent is capable of substituting, and when two or more substituents substitute, the two or more substituents may be the same as or different from each other.

In the present specification, a term "substituted or unsubstituted" means being unsubstituted or substituted with one or more substituents selected from the group consisting of deuterium; a halogen group; a cyano group; a nitro group; a hydroxyl group; a carbonyl group; an ester group; an imide group; an amide group; a primary amino group; a carboxyl group; a sulfonic acid group; a sulfonamide group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkoxysilylalkyl group; an arylphosphine group; or a heterocyclic group including one or more of N, O and S atoms, or being substituted with a substituent in which two or more of the substituents exemplified above are linked or being unsubstituted. For example, a "substituent in which two or more substituents are linked" may be a biphenyl group. In other words, a biphenyl group may be an aryl group, or may also be interpreted as a substituent in which two phenyl groups are linked.

Throughout the present specification, an "aliphatic ring group" or an "aromatic ring group" may be interpreted as a single ring that exists alone, or two or more rings joining together to form a fused ring, or two or more rings being linked by a direct bond, -O-, -S-, -C(=O)-, -CH(OH)-, -S(=O)₂-, -OCO-,-Si(CH₃)₂- or a substituted or unsubstituted alkylene group.

Throughout the present specification, -* represents a portion in which the corresponding group is linked to adjacent another atom.

Throughout the present specification, "-F" means a fluorine functional group included in a compound, and "-OH" means a hydroxyl functional group included in a compound.

Throughout the present specification, -F/-OH, a ratio between the number of -F functional groups and the number of -OH functional groups included in a polymer or a repeating unit, means a value calculated by dividing the total number of moles of -F functional groups included in a monomer used to polymerize a polymer or a repeating unit by the total number of moles of - OH functional groups.

Hereinafter, the present disclosure will be described in more detail.

### [Photosensitive Resin Composition]

One embodiment of the present disclosure provides a photosensitive resin composition including a polyimide including repeating units represented by the following Chemical Formulae 1 to 4, wherein a ratio between the total number of -F functional groups and the total number of -OH functional groups included in the repeating units represented by Chemical Formulae 1 to 4 satisfies 2≤-F/-OH≤5: 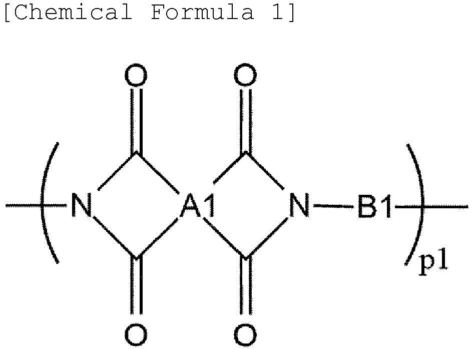 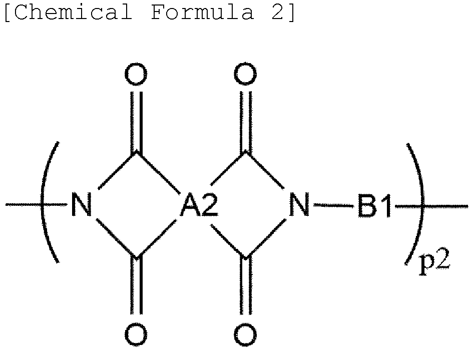 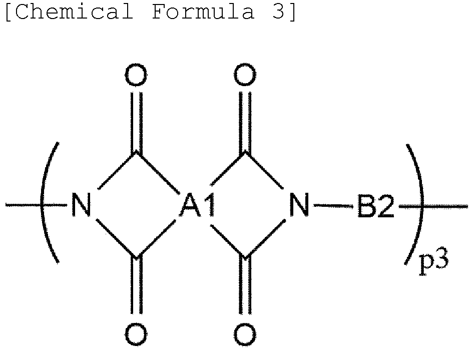 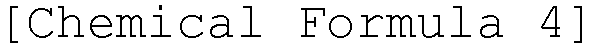 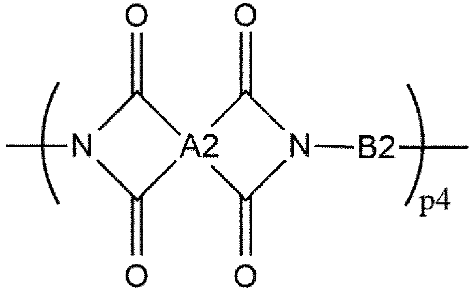 wherein in Chemical Formulae 1 to 4,
A1 is a tetravalent aliphatic organic group; A2 is a tetravalent aromatic ring group; B1 is a divalent aromatic ring group; B2 is a flexible functional group; p1 to p4 are each independently an integer of 1 to 10,000; and at least one of A1, A2, B1 and B2 includes -F, -OH or -F and -OH functional groups.

In general, a polyimide included in a photosensitive resin composition needs to include -F and -OH functional groups in order to be readily soluble in PGMEA, an environmental-friendly aqueous solvent, and developable with TMAH, an aqueous developing solution.

However, when -F and -OH functional groups included for the polyimide to be readily soluble in PGMEA, an environmental-friendly aqueous solvent, and developable with TMAH, an aqueous developing solution, increase, there are disadvantages in that properties such as dielectric loss (Df) and elongation become poor, and chemical resistance becomes poor as well.

The -F functional group has advantages in terms of solubility and low dielectric loss characteristics, but when included in excess, dielectric loss may be great, and film properties may decline. The -OH functional group has advantages in terms of development and solubility, but when the content increases, poor results may be caused in terms of reliability and the like due to its high hygroscopicity.

Since the ratio between the total number of -F functional groups and the total number of -OH functional groups included in the repeating units represented by Chemical Formulae 1 to 4 satisfies 2≤-F/-OH≤5, the photosensitive resin composition according to one embodiment of the present disclosure has advantages of being readily soluble in PGMEA, an environmental-friendly aqueous solvent, and developable with TMAH, an aqueous developing solution. In addition, at the same time, a photosensitive resin composition having low dielectric loss (Df) and dielectric constant (Dk), having excellent mechanical properties such as elongation, and also having excellent chemical resistance may be provided.

According to one embodiment of the present disclosure, the polyimide may include an end portion derived from an end-capping compound to describe later.

According to one embodiment of the present disclosure, the photosensitive resin composition may be a positive-type photosensitive resin composition, or a negative-type photosensitive resin composition.

According to one embodiment of the present disclosure, the polyimide may have a weight average molecular weight of 1,000 g/mol to 70,000 g/mol. More preferably, the polyimide may have a weight average molecular weight of 5,000 g/mol to 50,000 g/mol, 10,000 g/mol to 70,000 g/mol, 10,000 g/mol to 50,000 g/mol, 15,000 g/mol to 50,000 g/mol, 15,000 g/mol to 40,000 g/mol or 20,000 g/mol to 40,000 g/mol. When the polyimide resin has a weight average molecular weight of less than 1,000 g/mol, a produced insulating film may become brittle and have poor adhesive strength. In addition, the polyimide resin having a weight average molecular weight of greater than 70,000 g/mol is not preferred since the composition may not be developed due to decreased sensitivity, or scum may remain.

The -F/-OH ratio preferably satisfies 2.1 or greater, more preferably satisfies 2.5 or greater, and even more preferably satisfies 3.0 or greater. In addition, the -F/-OH ratio preferably satisfies 4.8 or less, more preferably satisfies 4.5 or less or 4.3 or less, and even more preferably satisfies 4.0 or less.

When the -F/-OH ratio is less than 2, there are problems in that the dielectric loss value increases, chemical resistance decreases, and reliability decreases as hygroscopicity increases due to the relatively high -OH functional group ratio.

Meanwhile, when the -F/-OH ratio is greater than 5, there are problems in that the dielectric loss increases, and mechanical properties and chemical resistance of the film decrease.

The repeating unit represented by Chemical Formula 1 includes A1, an aliphatic moiety derived from an aliphatic dianhydride monomer, and B1, an aromatic moiety derived from a diamine monomer that does not include a flexible functional group, and the repeating unit represented by Chemical Formula 2 includes A2, an aromatic moiety derived from an aromatic dianhydride monomer, and B1, an aromatic moiety derived from a diamine monomer that does not include a flexible functional group, the repeating unit represented by Chemical Formula 3 includes A1, an aliphatic moiety derived from an aliphatic dianhydride monomer, and B2, a flexible moiety derived from a diamine monomer including a flexible functional group, and the repeating unit represented by Chemical Formula 4 includes A2, an aromatic moiety derived from an aromatic dianhydride monomer, and B2, a flexible moiety derived from a diamine monomer including a flexible functional group.

A general photosensitive resin composition includes a polymer of an aromatic dianhydride monomer and a diamine monomer that does not include a flexible functional group, however, the photosensitive resin composition according to one embodiment of the present disclosure uses an aliphatic moiety-introduced aliphatic dianhydride monomer to reduce a dielectric loss value, and uses a diamine monomer including a flexible functional group to enhance elongation.

However, when the aliphatic moiety included in the polyimide to reduce the dielectric loss value and the flexible moiety included in the polyimide to enhance elongation are included outside an appropriate content range, properties of the photosensitive resin composition may decline, and these moieties need to be included in an appropriate ratio.

Specifically, the photosensitive resin composition according to one embodiment of the present disclosure has advantages of being readily soluble in PGMEA, an environmental-friendly aqueous solvent, and developable with TMAH, an aqueous developing solution, and in order to provide a photosensitive resin composition having excellent properties such as dielectric loss and elongation, and excellent chemical resistance as well, the polyimide including the repeating units represented by Chemical Formulae 1 to 4 includes the aliphatic moiety and the flexible moiety in an appropriate amount.

According to one embodiment of the present disclosure, the ratio of the total number of the repeating units represented by Chemical Formulae 1 and 3 with respect to the total number of the repeating units represented by Chemical Formulae 2 and 4 may satisfy 0.01 to 1.0.

Since the ratio of the total number of the repeating units represented by Chemical Formulae 1 and 3 with respect to the total number of the repeating units represented by Chemical Formulae 2 and 4 satisfies 0.01 to 1.0, the content of the aliphatic moiety included in the polyimide is appropriate, and as a result, the photosensitive resin composition is readily soluble in PGMEA, an environmental-friendly aqueous solvent, and developable with TMAH, an aqueous developing solution, and at the same time, may have a low dielectric loss (D_{f}) value.

More specifically, the ratio of the total number of the repeating units represented by Chemical Formulae 1 and 3 with respect to the total number of the repeating units represented by Chemical Formulae 2 and 4 preferably satisfies 0.01 or greater, more preferably satisfies 0.05 or greater, and even more preferably satisfies 0.1 or greater. In addition, the ratio of the total number of the repeating units represented by Chemical Formulae 1 and 3 with respect to the total number of the repeating units represented by Chemical Formulae 2 and 4 preferably satisfies 1.0 or less, more preferably satisfies 0.9 or less or 0.8 or less, and even more preferably satisfies 0.7 or less.

When the ratio of the total number of the repeating units represented by Chemical Formulae 1 and 3 with respect to the total number of the repeating units represented by Chemical Formulae 2 and 4 is less than 0.01, it is difficult to dissolve the composition in PGMEA, an environmental-friendly aqueous solvent, or developability with TMAH, an aqueous developing solution, may be reduced, and when the ratio is greater than 1.0, properties of dielectric loss may decline.

According to one embodiment of the present disclosure, the ratio of the total number of the repeating units represented by Chemical Formulae 1 and 3 with respect to the total number of the repeating units represented by Chemical Formulae 1 to 4 may be from 0.05 to 0.5. By satisfying the above-mentioned ratio, a photosensitive resin composition readily soluble in PGMEA, an environmental-friendly aqueous solvent, developable with TMAH, an aqueous developing solution, and having a low dielectric loss value at the same time may be obtained.

When the ratio of the total number of the repeating units represented by Chemical Formulae 1 and 3 with respect to the total number of the repeating units represented by Chemical Formulae 1 to 4 is less than 0.05, it is difficult to dissolve the composition in PGMEA, an environmental-friendly aqueous solvent, or developability with TMAH, an aqueous developing solution, may be reduced, and when the ratio is greater than 0.5, properties of dielectric loss may decline.

According to one embodiment of the present disclosure, the ratio of the total number of the repeating units represented by Chemical Formulae 3 and 4 with respect to the total number of the repeating units represented by Chemical Formulae 1 to 4 may be from 0.05 to 0.5.

When the ratio of the total number of the repeating units represented by Chemical Formulae 3 and 4 with respect to the total number of the repeating units represented by Chemical Formulae 1 to 4 satisfies 0.05 to 0.5, the content of the flexible moiety included in the polyimide is appropriate, and as a result, a photosensitive resin composition readily soluble in PGMEA, an environmental-friendly aqueous solvent, developable with TMAH, an aqueous developing solution, and having excellent adhesiveness and excellent elongation and chemical resistance characteristics at the same time may be obtained.

When the ratio of the total number of the repeating units represented by Chemical Formulae 3 and 4 with respect to the total number of the repeating units represented by Chemical Formulae 1 to 4 is less than 0.05, it is difficult to dissolve the composition in PGMEA, an environmental-friendly aqueous solvent, and problems such as reduced developability with TMAH, an aqueous developing solution, and reduced adhesiveness may occur, and when the ratio is greater than 0.5, elongation and chemical resistance characteristics may decline.

According to one embodiment of the present disclosure, the tetravalent aliphatic organic group (A1) may include one or more types selected from among a substituted or unsubstituted tetravalent aliphatic ring group, the following Chemical Formula 5 and the following Chemical Formula 6.

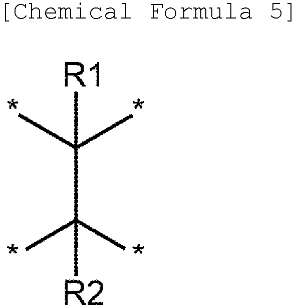

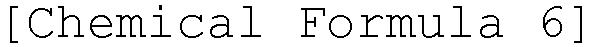

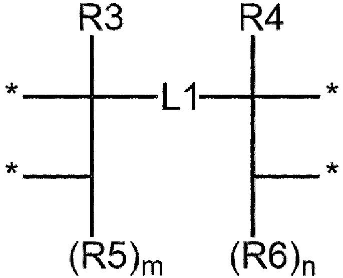

In Chemical Formulae 5 and 6, L1 is a direct bond; a substituted or unsubstituted alkylene group; -O-; -SO₂-; -CO-; or -OCO-, R1 to R6 are the same as or different from each other and are each independently hydrogen; a substituted or unsubstituted alkyl group; or a carboxyl group, m and n are 2, R5s are the same as or different from each other, and R6s are the same as or different from each other.

More specifically, the tetravalent aliphatic organic group (A1) may include one or more types selected from among the following chemical formulae.

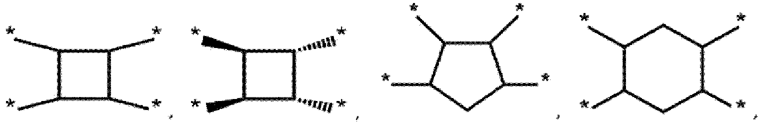

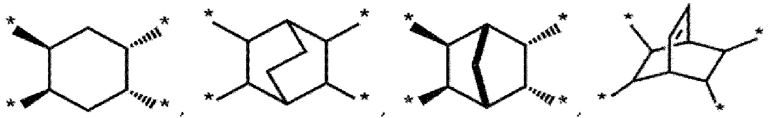

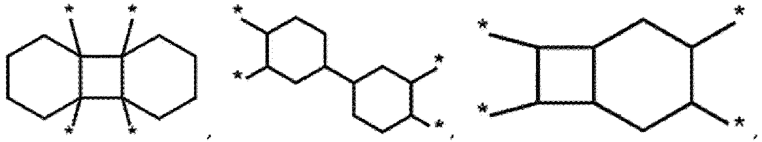

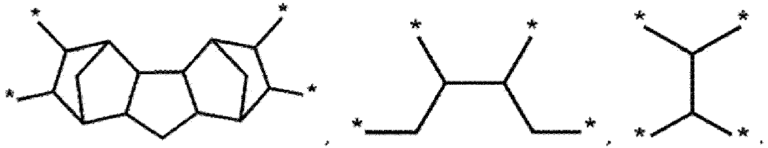

According to one embodiment of the present disclosure, the tetravalent aromatic ring group (A2) may include one or more types selected from among a substituted or unsubstituted tetravalent aromatic single ring and the following Chemical Formula 7.

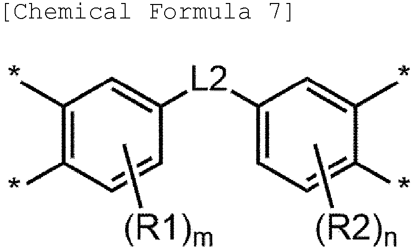

In Chemical Formula 7, L2 is a direct bond; a substituted or unsubstituted alkylene group; a substituted or unsubstituted arylene group; -O-; -SO₂-; -CO-; or -OCO-, R1 and R2 are the same as or different from each other and each independently hydrogen; a substituted or unsubstituted alkyl group; or a carboxyl group, m and n are the same as or different from each other, and each independently an integer of 0 to 3, when m is 2 or greater, R1s are the same as or different from each other, and when n is 2 or greater, R2s are the same as or different from each other.

According to one embodiment of the present disclosure, the divalent aromatic ring group (B1) may include one or more types selected from among a substituted or unsubstituted divalent aromatic single ring, the following Chemical Formula 8 and the following Chemical Formula 9.

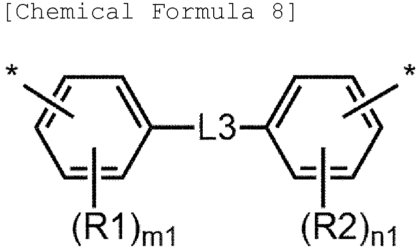

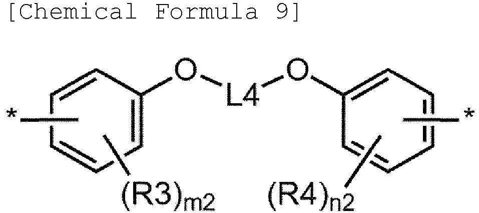

In Chemical Formulae 8 and 9, L3 and L4 are the same as or different from each other and each independently a direct bond; a substituted or unsubstituted alkylene group; a substituted or unsubstituted arylene group; -O-; -SO₂-; -CO-; or -OCO-, R1 to R4 are the same as or different from each other and each independently hydrogen; a substituted or unsubstituted alkyl group; a substituted or unsubstituted alkoxy group; a hydroxyl group; or a substituted or unsubstituted amine group, m1, m2, n1 and n2 are the same as or different from each other and are each independently an integer of 0 to 4, when m1 is 2 or greater, R1s are the same as or different from each other, when n1 is 2 or greater, R2s are the same as or different from each other, when m2 is 2 or greater, R3s are the same as or different from each other, and when n2 is 2 or greater, R4s are the same as or different from each other.

According to one embodiment of the present disclosure, the flexible functional group (B2) may include one or more types selected from among the following Chemical Formulae 10 to 13.

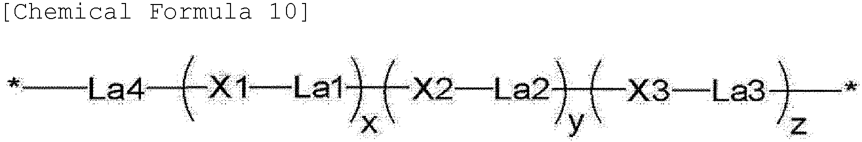

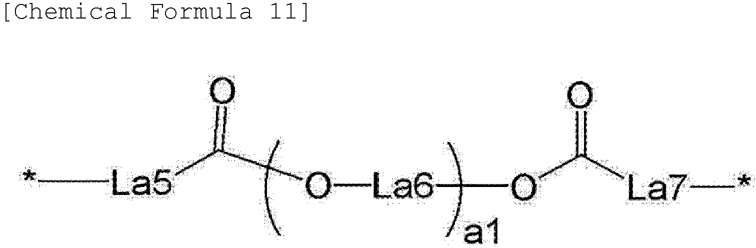

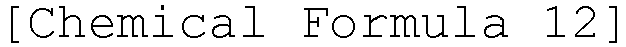

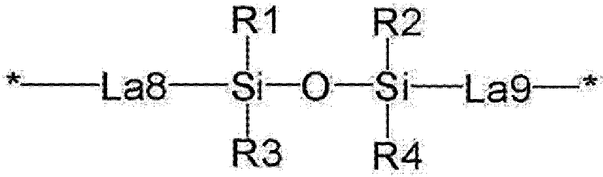

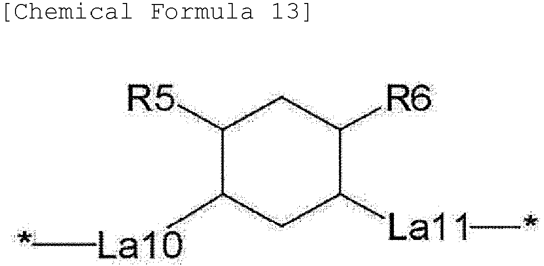

In Chemical Formulae 10 to 13, X1 to X3 are the same as or different from each other and are each independently -O-; or - CH₂-, La1 to La11 are the same as or different from each other and are each independently a substituted or unsubstituted alkylene group; or a substituted or unsubstituted arylene group, R1 to R6 are the same as or different from each other and are each independently hydrogen; or a substituted or unsubstituted alkyl group, x, y and z are each independently a real number of 0 to 50, and a1 is a real number of 1 to 30.

More specifically, the flexible functional group (B2) may include one or more types selected from among the following chemical formulae.

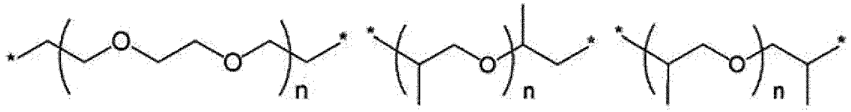

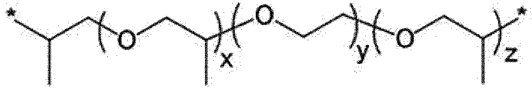

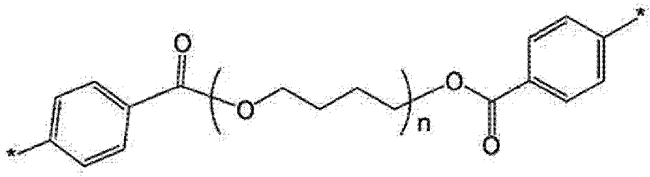

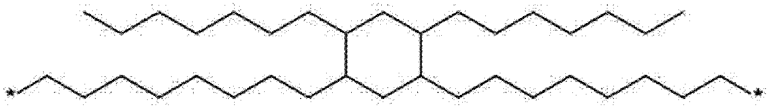

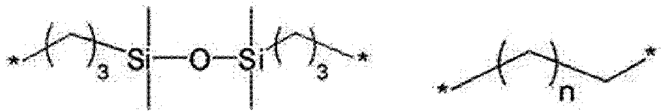

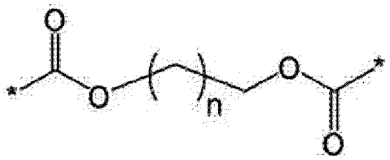

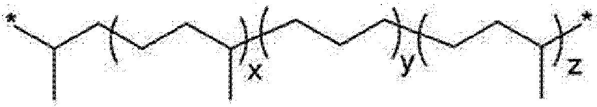

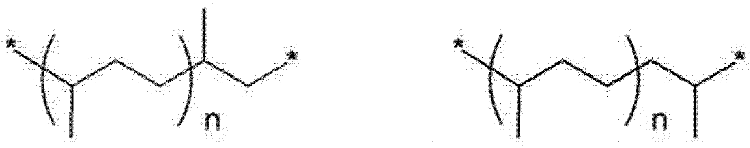

In the chemical formulae, ns are each independently a real number of 1 to 30, and x, y and z are each independently a real number of 1 to 50.

### [Monomer for Polyimide Synthesis]

In the polyimide including the repeating units represented by Chemical Formulae 1 to 4, each of the repeating units may be obtained by reacting dianhydride and diamine. More specifically, the dianhydride may be tetracarboxylic dianhydride.

Specifically, the repeating unit represented by Chemical Formula 1 may be obtained by reacting an aliphatic dianhydride monomer with a diamine monomer that does not include a flexible functional group, the repeating unit represented by Chemical Formula 2 may be obtained by reacting an aromatic dianhydride monomer with a diamine monomer that does not include a flexible functional group, the repeating unit represented by Chemical Formula 3 may be obtained by reacting an aliphatic dianhydride monomer with a diamine monomer including a flexible functional group, and the repeating unit represented by Chemical Formula 4 may be obtained by reacting an aromatic dianhydride monomer with a diamine monomer including a flexible functional group.

### Aliphatic Dianhydride Monomer

According to one embodiment of the present disclosure, the aliphatic dianhydride monomer may include one or more types selected from among the following Chemical Formulae 14 to 16.

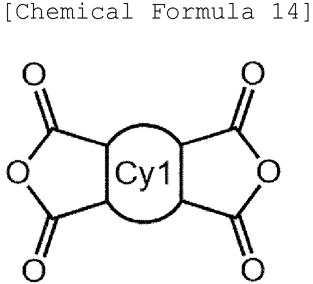

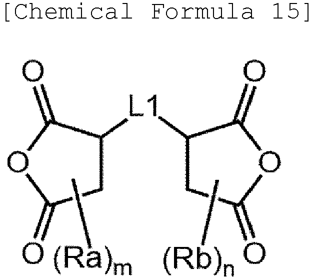

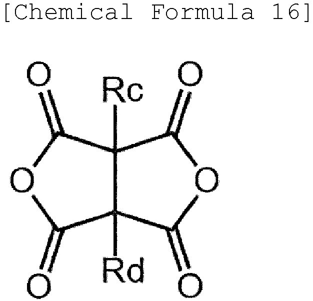

In Chemical Formulae 14 to 16, Cy1 is a substituted or unsubstituted aliphatic single ring, L1 is a direct bond; a substituted or unsubstituted alkylene group; -O-; -SO₂-; -CO-; or -OCO-, Ra to Rd are the same as or different from each other and each independently hydrogen; a substituted or unsubstituted alkyl group; or a carboxyl group, m and n are the same as or different from each other and each independently an integer of 0 to 3, when m is 2 or greater, Ras are the same as or different from each other, and when n is 2 or greater, Rbs are the same as or different from each other.

More specifically, the aliphatic dianhydride monomer may include one or more types selected from among the following chemical formulae.

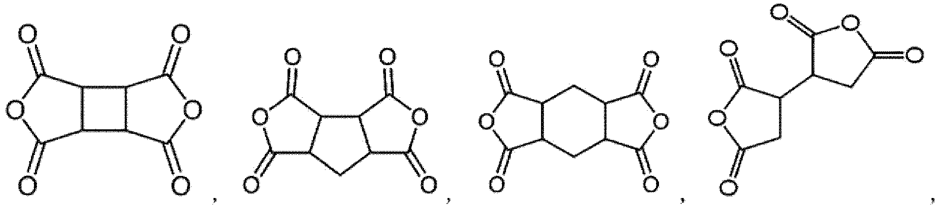

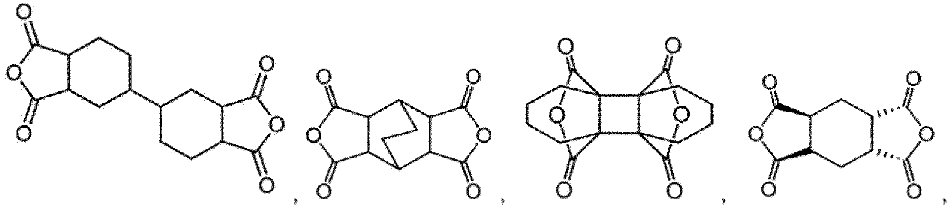

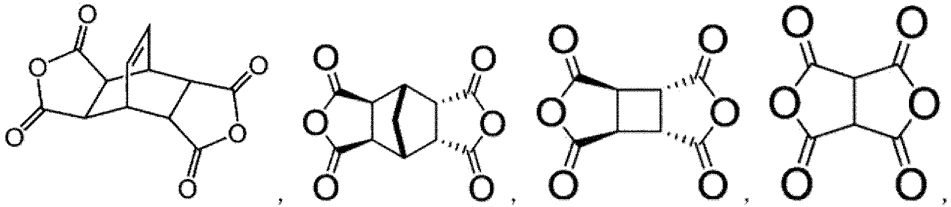

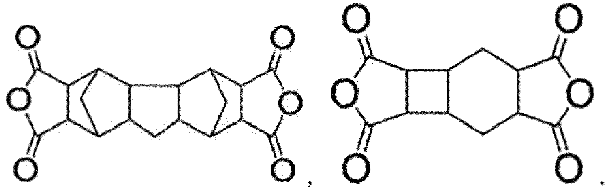

According to one embodiment of the present disclosure, the aliphatic dianhydride monomer may include an aliphatic dianhydride monomer including a substituted or unsubstituted alkyl group and an aliphatic dianhydride monomer including a substituted or unsubstituted aliphatic ring. When the aliphatic dianhydride monomer includes both the monomers, the photosensitive resin composition including the polyimide polymerized therefrom has advantages of being readily soluble in PGMEA, an environmental-friendly aqueous solvent, and developable with TMAH, an aqueous developing solution, and at the same time, has excellent film properties due to reduced dielectric loss (Df), and may also have excellent chemical resistance.

### Aromatic Dianhydride Monomer

According to one embodiment of the present disclosure, the aromatic dianhydride monomer may include one or more types selected from among the following Chemical Formulae 17 and 18.

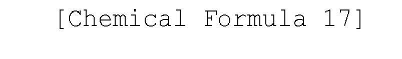

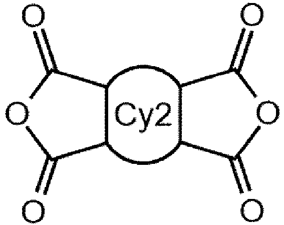

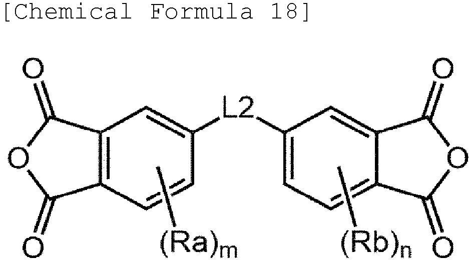

In Chemical Formula 17, Cy2 is a substituted or unsubstituted aromatic ring group, in Chemical Formula 18, L2 is a direct bond; a substituted or unsubstituted alkylene group; a substituted or unsubstituted arylene group; -O-; -SO₂-; -CO-; or -OCO-, Ra and Rb are the same as or different from each other and each independently hydrogen; a substituted or unsubstituted alkyl group; or a carboxyl group, m and n are the same as or different from each other and each independently an integer of 0 to 3, when m is 2 or greater, Ras are the same as or different from each other, and when n is 2 or greater, Rbs are the same as or different from each other.

According to one embodiment of the present disclosure, the aromatic dianhydride monomer may include one or more types selected from among the following chemical formulae, but is not limited thereto.

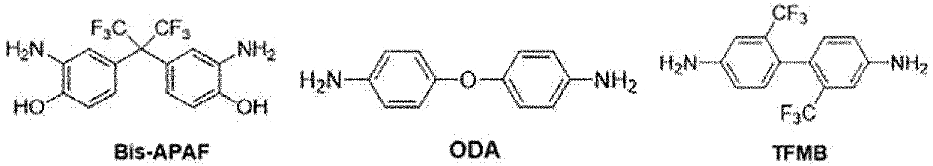

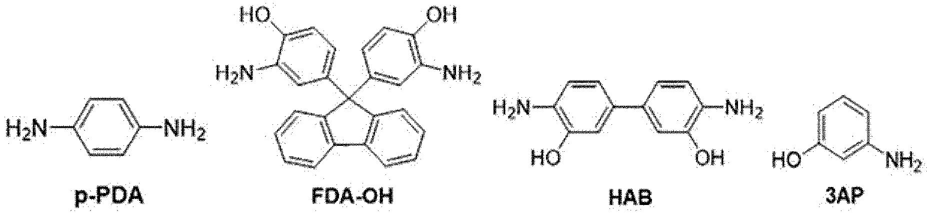

### Diamine Monomer That Does Not Include Flexible Functional Group

According to one embodiment of the present disclosure, the diamine monomer that does not include a flexible functional group may include one or more types selected from among the following Chemical Formulae 19 to 21.

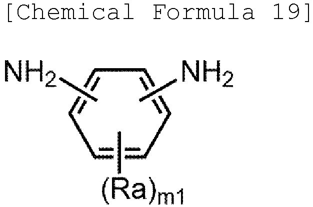

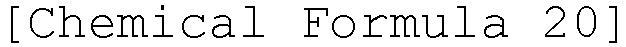

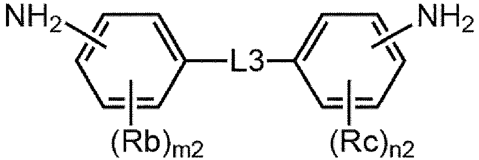

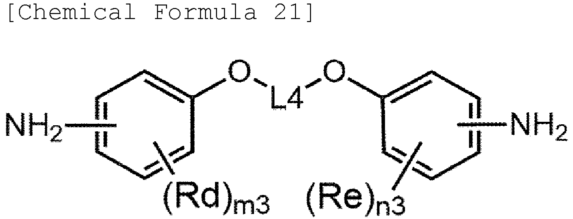

In Chemical Formulae 19 to 21, L3 and L4 are the same as or different from each other and each independently a direct bond; a substituted or unsubstituted alkylene group; a substituted or unsubstituted arylene group; -O-; -SO₂-; -CO-; or -OCO-, Ra to Re are the same as or different from each other and each independently hydrogen; a substituted or unsubstituted alkyl group; a substituted or unsubstituted alkoxy group; a hydroxyl group; or a substituted or unsubstituted amine group, m1, m2, m3, n2 and n3 are the same as or different from each other and each independently an integer of 0 to 4, when m1 is 2 or greater, Ras are the same as or different from each other, when m2 is 2 or greater, Rbs are the same as or different from each other, when m3 is 2 or greater, Rds are the same as or different from each other, when n2 is 2 or greater, Rcs are the same as or different from each other, and when n3 is 2 or greater, Res are the same as or different from each other

### Diamine Monomer Including Flexible Functional Group

According to one embodiment of the present disclosure, the diamine monomer including a flexible functional group may have an amine group bonding to each end of the above-described flexible functional group.

Specifically, the amine group may bond to both ends of any one flexible functional group selected from among Chemical Formulae 10 to 13 or a flexible functional group in which two or more types thereof bond to each other.

### End-capping Compound

According to one embodiment of the present disclosure, the polyimide polymerized from the dianhydride monomer and the diamine monomer may be end-capped by an end-capping compound.

According to one embodiment of the present disclosure, the end-capping compound may be a monoamine compound including one amine group, a monoanhydride compound, or a mixture thereof.

For example, the end-capping compound may be trimellitic anhydride, phthalic anhydride, 5-norbornene-2,3-dicarboxylic anhydride, 3-aminophenol (3AP) or a mixture thereof.

### [Additive]

According to one embodiment of the present disclosure, the photosensitive resin composition may further include one or more types selected from among a photosensitive agent, a cross-linking agent, an antioxidant, a surfactant and a solvent. In addition, the photosensitive resin composition may further include additives known in the art depending on the application.

The photosensitive agent may include a photoacid generator, or a combination of a photopolymerization initiator and a compound having two or more ethylenically unsaturated bonds. By including a photoacid generator, an acid is generated in a light irradiated portion to increase solubility of the light irradiated portion for an aqueous alkaline solution, and as a result, a positive-type relief pattern in which the light irradiated portion is dissolved is able to be obtained. In addition, by including a photoacid generator and an epoxy compound or a cross-linking agent, an acid generated in a light irradiated portion accelerates a cross-linking reaction of the epoxy compound or the cross-linking agent, and as a result, a negative-type relief pattern in which the light irradiated portion becomes insoluble is able to be obtained as well. In addition, by including a photopolymerization initiator and a compound having two or more ethylenically unsaturated bonds, active radicals generated in a light irradiated portion progresses radical polymerization of the ethylenically unsaturated bonds, and as a result, a negative-type relief pattern in which the light irradiated portion becomes insoluble is able to be obtained as well.

The photoacid generator may include a quinonediazide compound, a sulfonium salt, a phosphonium salt, a diazonium salt, an iodonium salt and the like.

The quinonediazide compound may include a compound in which sulfonic acid of quinonediazide ester bonds to a polyhydroxy compound, a compound in which sulfonic acid of quinonediazide sulfonamide bonds to a polyamino compound, a compound in which sulfonic acid of quinonediazide ester bonds and/or sulfonamide bonds to a polyhydroxypolyamino compound, and the like. It is preferred that 50 mol% or more of all functional groups of these polyhydroxy compounds or polyamino compounds are substituted with quinonediazide. By substituting 50 mol% or more of the functional groups with quinonediazide, solubility of a resin film for an alkaline developing solution becomes favorable in an exposed area, and there is an advantage of obtaining a fine pattern having a high contrast with an unexposed area. In addition, it is preferred to contain two or more types of photoacid generators, and as a result, a heat resistant resin composition having highly sensitive photosensitive characteristics may be obtained.

As the quinonediazide compound, a compound having a 5-naphthoquinonediazide sulfonyl group and a compound having a 4-naphthoquinonediazide sulfonyl group may all be preferably used. A 4-naphthoquinonediazide sulfonyl ester compound has absorption in the i-line region of a mercury lamp and is thereby suitable for i-line exposure. A 5-naphthoquinonediazide sulfonyl ester compound has absorption up to the g-line region of a mercury lamp and is thereby suitable for g-line exposure. It is preferred to select a 4-naphthoquinonediazide sulfonyl ester compound or a 5-naphthoquinonediazide sulfonyl ester compound depending on the exposure wavelength. In addition, a naphthoquinonediazide sulfonyl ester compound having a 4-naphthoquinonediazide sulfonyl group and a 5-naphthoquinonediazide sulfonyl group in the same molecule may be included, or both a 4-naphthoquinonediazide sulfonyl ester compound and a 5-naphthoquinonediazide sulfonyl ester compound may be included.

A sulfonium salt, a phosphonium salt and a diazonium salt are preferred as the photoacid generator since they appropriately stabilize an acid component generated by exposure. Among these, a sulfonium salt is preferred. A sensitizer and the like may be further included as necessary.

The photopolymerization initiator may include diethoxyacetophenone, 2-hydroxy-2-methyl-1-phenylpropan-1-one, benzyl dimethyl ketal, 1-(4-isopropylphenyl)-2-hydroxy-2-methylpropan-1-one, 4-(2-hydroxyethoxy)phenyl-(2-hydroxy-2-propyl) ketone, 1-hydroxycyclohexyl-phenylketone, 1-phenyl-1,2-propanedione-2-(o-ethoxycarbonyl)oxime, 2-methyl-[4-(methylthio)phenyl]-2-morpholinopropan-1-one, 2-benzyl-2-dimethylamino-1-(4-morpholinophenyl)-butanone-1, benzoin, benzoin methyl ether, benzoin ethyl ether, benzoin isopropyl ether, benzoin isobutyl ether, benzophenone, o-methyl-benzoyl benzoate, 4-phenylbenzophenone, 4,4-dichlorobenzophenone, hydroxybenzophenone, 4-benzoyl-4'-methyl-diphenylsulfide, alkylated benzophenone, 3,3',4,4'-tetra(t-butylperoxycarbonyl)benzophenone, 4-benzoyl-N,N-dimethyl-N-[2-(1-oxo-2-propenyloxy)ethyl]benzenemethaneaminium bromide, (4-benzoylbenzyl)trimethylammonium chloride, 2-hydroxy-3-(4-benzoylphenoxy)-N,N,N-trimethyl-1-propenaminium chloride monohydrate, 2-isopropylthioxanthone, 2,4-dimethylthioxanthone, 2,4-diethylthioxanthone, 2,4-dichlorothioxanthone, 2-hydroxy-3-(3,4-dimethyl-9-oxo-9H-thioxanthen-2-yloxy)-N,N,N-trimethyl-1-propanaminium chloride, 2,4,6-trimethylbenzoylphenylphosphine oxide, 1,2-octanedione-1-[4-(phenylthio)-2-(o-benzoyloxime)], ethanone, 1-[8-ethyl-6-(2-methylbenzoyl)-9H-carbazol-3-yl]-, 1-(o-acetyloxime), 2,2'-bis(o-chlorophenyl)-4,5,4',5'-tetraphenyl-1,2-biimidazole, 10-butyl-2-chloroacridone, 2-ethylanthraquinone, benzyl, 9,10-phenanthrenequinone, camphorquinone, methylphenylglyoxyester, η5-cyclopentadienyl-η6-cumenyl-iron(1+)-hexafluorophosphate(1-), a diphenylsulfide derivative, bis(η5-2,4-cyclopentadien-1-yl)-bis(2,6-difluoro-3-(1H-pyrrol-1-yl)-phenyl)titanium, 4,4-bis(dimethylamino)benzophenone, 4,4-bis(diethylamino)benzophenone, thioxanthone, 2-methylthioxanthone, 2-chlorothioxanthone, 4-benzoyl-4-methylphenylketone, dibenzylketone, fluorenone, 2,3-diethoxyacetophenone, 2,2-dimethoxy-2-phenyl-2-phenylacetophenone, 2-hydroxy-2-methylpropiophenone, p-t-butyl dichloroacetophenone, benzyl methoxyethyl acetal, anthraquinone, 2-t-butylanthraquinone, 2-aminoanthraquinone, β-chloroanthraquinone, anthrone, benzanthrone, dibenzosuberone, methyleneanthrone, 4-azidobenzalacetophenone, 2,6-bis(p-azidobenzylidene)cyclohexane, 2,6-bis(p-azidobenzylidene)-4-methylcyclohexanone, 2-phenyl-1,2-butadione-2-(o-methoxycarbonyl) oxime, 1,3-diphenylpropanetrione-2-(o-ethoxycarbonyl) oxime, naphthalenesulfonyl chloride, quinolinesulfonyl chloride, N-phenylthioacridone, 4,4-azobisisobutyronitrile, benzothiazole disulfide, triphenylphosphine, carbon tetrabromide, tribromophenylsulfone, benzoyl peroxide and the like, or a combination of a photoreducible dye such as eosin or methylene blue and a reducing agent such as ascorbic acid or triethanolamine, and the like. Two or more types thereof may be included.

The content of the photosensitive agent is preferably from 0.05 parts by weight to 50 parts by weight with respect to 100 parts by weight of the polyimide. When the photosensitive agent is the photoacid generator, the content is preferably from 0.01 parts by weight to 50 parts by weight with respect to 100 parts by weight of the polyimide from the perspective of high sensitivity. The content of the quinonediazide compound in the photoacid generator is preferably from 3 parts by weight to 40 parts by weight. In addition, as for the content of the sulfonium salt, the phosphonium salt and the diazonium salt, the total content of these is preferably from 0.5 parts by weight to 20 parts by weight with respect to 100 parts by weight of the polyimide. This content range is preferred since a sufficient acid is generated by light irradiation and sensitivity is improved. In addition, the content of the photoacid generator being 20 parts by weight or less is preferred since no developed pattern residue is generated.

The content of the photopolymerization initiator is preferably from 0.1 parts by weight to 20 parts by weight with respect to 100 parts by weight of the polyimide. When the content is 0.1 parts by weight or greater, sufficient radicals are generated by light irradiation, and sensitivity is improved. In addition, when the content is 20 parts by weight or less, the unirradiated portion is not cured due to excessive generation of radicals, and alkaline developability is improved. The content of the compound having two or more ethylenically unsaturated bonds is preferably from 5 parts by weight to 50 parts by weight with respect to 100 parts by weight of the polyimide. The content of 5 parts by weight or greater is preferred since a cured resin film with high mechanical properties is obtained by cross-linking. The content of 50 parts by weight or less is preferred since sensitivity is not damaged.

The cross-linking agent is not particularly limited, and those used in the art may be used without limit. For example, as the cross-linking agent, a thermal cross-linking agent or a radical monomer may be used. More specifically, as the cross-linking agent, a compound having at least two alkoxymethyl groups and/or methylol groups, and a compound having at least two epoxy groups and/or oxetanyl groups may be used, however, the cross-linking agent is not limited thereto. By including these compounds, a condensation reaction occurs with the polyimide resin during baking after patterning to form a crosslinked structure, and mechanical properties such as elongation of the cured resin pattern may be improved. In addition, two or more types of the cross-linking agent may be used, which enables a broader design range.

Preferred examples of the compound having at least two alkoxymethyl groups and/or methylol groups may include DML-PC, DML-PEP, DML-OC, DML-OEP, DML-34X, DML-PTBP, DML-PCHP, DML-OCHP, DML-PFP, DML-PSBP, DML-POP, DML-MBOC, DMLMBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOMBPE, TMOM-BPA, TMOM-BPAF, TMOM-BPAP, HML-TPPHBA, HML-TPHAP, HMOM-TPPHBA and HMOM-TPHAP (hereinbefore, brand name, manufactured by Honshu Chemical Industry Co., Ltd.), and NIKALAC (registered trademark) MX-290, NIKALAC MX-280, NIKALAC MX-270, NIKALAC MX-279, NIKALAC MW-100LM and NIKALAC MX-750LM (hereinbefore, brand name, manufactured by Sanwa Chemical Co., Ltd.), which are available from each company. Two or more types thereof may be included.

In addition, preferred examples of the compound having at least two epoxy groups and/or oxetanyl groups include a bisphenol A-type epoxy resin, a bisphenol A-type oxetanyl resin, a bisphenol F-type epoxy resin, a bisphenol F-type oxetanyl resin, propylene glycol diglycidyl ether, polypropylene glycol diglycidyl ether, epoxy group-containing silicone such as polymethyl(glycidyloxypropyl)siloxane, and the like, however, the compound is not limited thereto. Specifically, EPICLON (registered trademark) 850-S, EPICLON HP-4032, EPICLON HP-7200, EPICLON HP-820, EPICLON HP-4700, EPICLON EXA-4710, EPICLON HP-4770, EPICLON EXA-859CRP, EPICLON EXA-1514, EPICLON EXA-4880, EPICLON EXA-4850-150, EPICLON EXA-4850-1000, EPICLON EXA-4816 and EPICLON EXA-4822 (hereinbefore, brand name, manufactured by Dainippon Ink & Chemicals, Inc.), RIKARESIN (registered trademark) BEO-60E (brand name, manufactured by New Japan Chemical Co., Ltd.), EP-4003S and EP-4000S (brand name, manufactured by ADEKA Corporation), and the like, which are available from each company, may be included. Two or more types thereof may be included.

In addition, as the cross-linking agent, 2-[[4-[2-[4-[1,1-bis[4-(oxiran-2-ylmethoxy)phenyl]ethyl]phenyl]propan-2-yl]phenoxy]methyl]oxirane, tetraethylene glycol dimethyl acrylate and the like may be used.

The content of the cross-linking agent is preferably 0.5 parts by weight or greater, more preferably 1 part by weight or greater, and even more preferably 10 parts by weight or greater with respect to 100 parts by weight of the polyimide, and, from the perspective of maintaining mechanical properties such as elongation, is preferably 300 parts by weight or less, and more preferably 200 parts by weight or less.

In one embodiment of the present disclosure, in order to improve resolution of a relief pattern, the photosensitive resin composition may further include a monomer having a photopolymerizable unsaturated bond.

As such a monomer, a (meth)acrylic compound that undergoes a radical polymerization reaction by a photopolymerization initiator is preferred, and, although not particularly limited to the following, examples thereof may include mono- or diacrylate and methacrylate of ethylene glycol or polyethylene glycol including diethylene glycol dimethacrylate and tetraethylene glycol dimethacrylate, mono- or diacrylate and methacrylate of propylene glycol or polypropylene glycol, mono-, di- or triacrylate and methacrylate of glycerol, cyclohexane diacrylate and dimethacrylate, diacrylate and dimethacrylate of 1,4-butanediol, diacrylate and dimethacrylate of 1,6-hexanediol, diacrylate and dimethacrylate of neopentyl glycol, mono- or diacrylate and methacrylate of bisphenol A, benzene trimethacrylate, isobornyl acrylate and methacrylate, acrylamide and derivatives thereof, methacrylamide and derivatives thereof, trimethylolpropane triacrylate and methacrylate, di- or triacrylate and methacrylate of glycerol, di-, tri- or tetraacrylate and methacrylate of pentaerythritol, and compounds such as ethylene oxide or propylene oxide adducts of these compounds.

The content of the monomer having a photopolymerizable unsaturated bond is preferably from 1 part by weight to 50 parts by weight with respect to 100 parts by weight of the polyimide.

The antioxidant may perform a role of improving elongation characteristics of the after-curing film after reliability evaluation, or adhesion to metal materials. In addition, the antioxidant may suppress oxidation degradation of an aliphatic group or a phenolic hydroxyl group of the polyimide resin, and may suppress metal oxidation by an anti-rust action on metal materials. Specific examples of the antioxidant may include the following compounds and the like, but are not limited thereto.

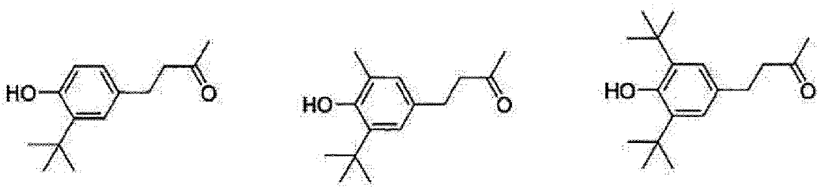

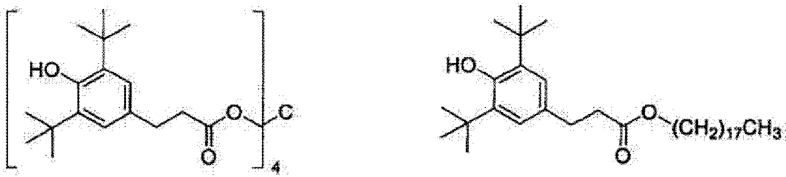

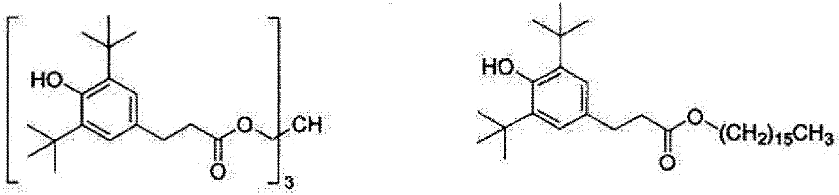

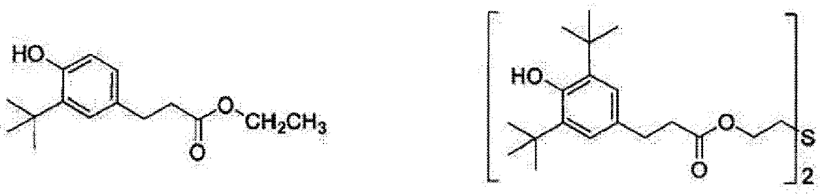

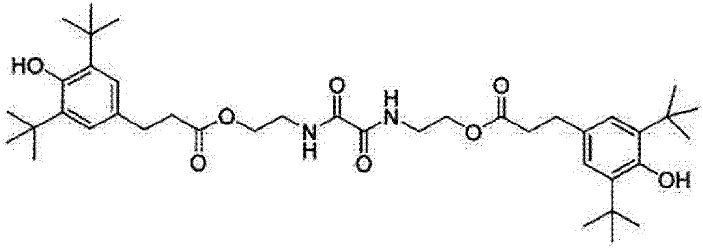

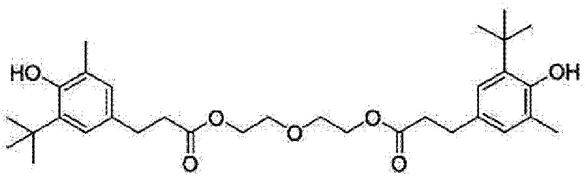

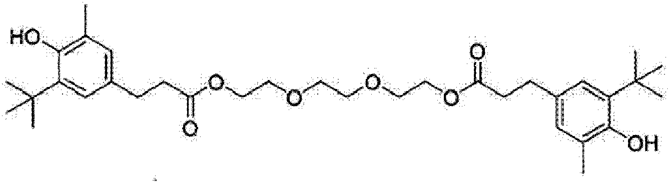

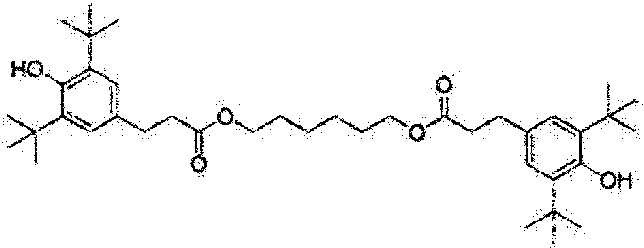

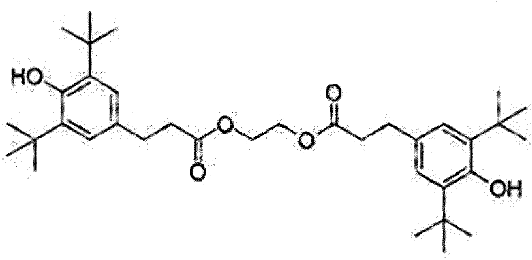

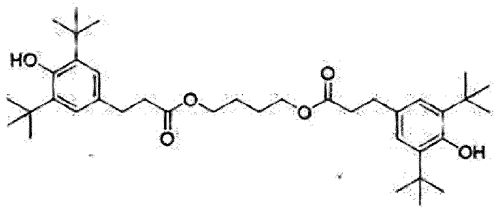

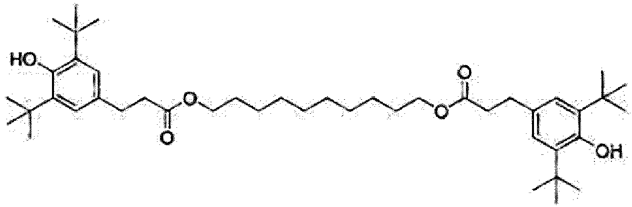

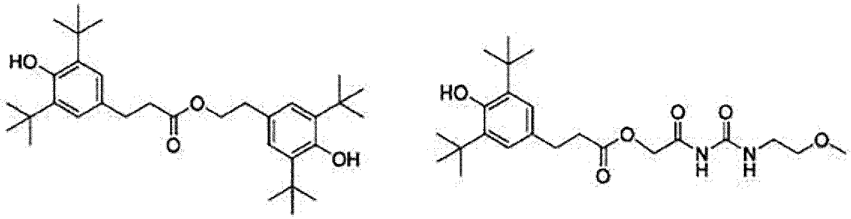

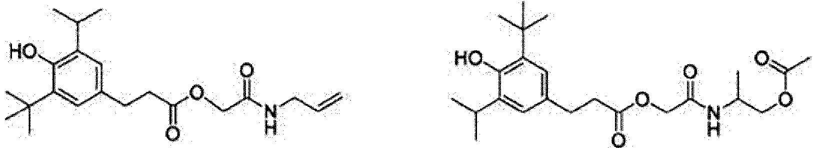

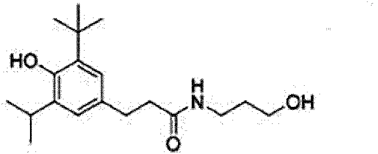

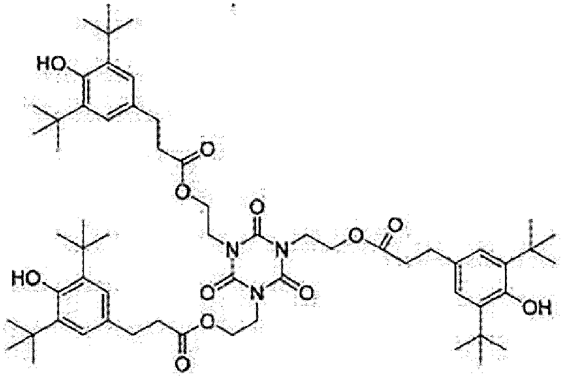

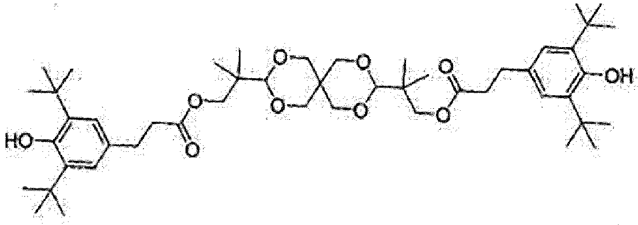

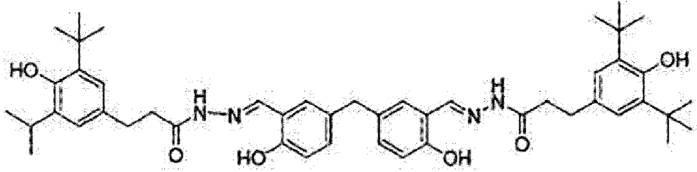

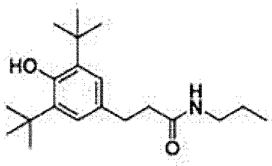

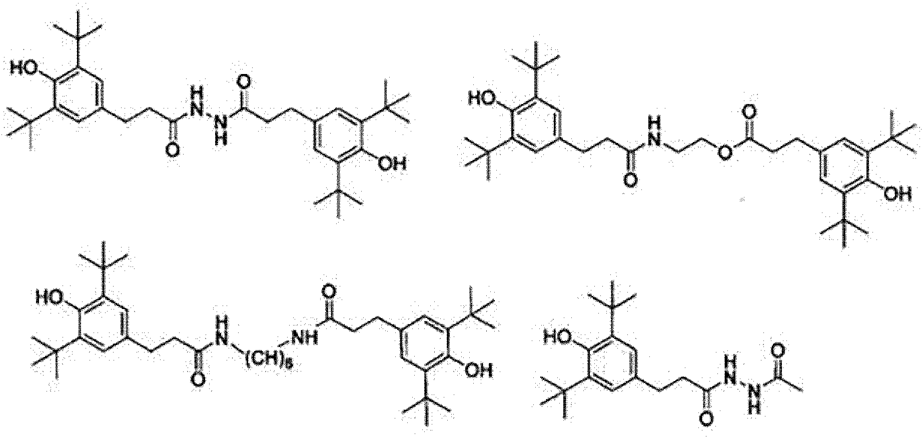

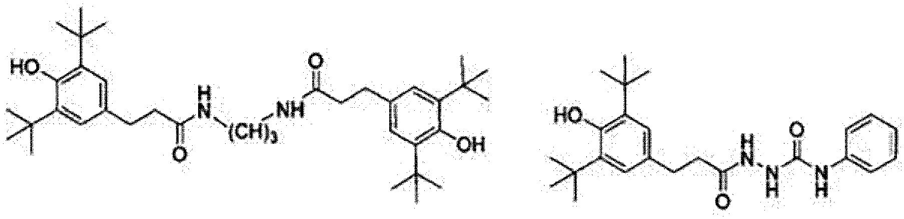

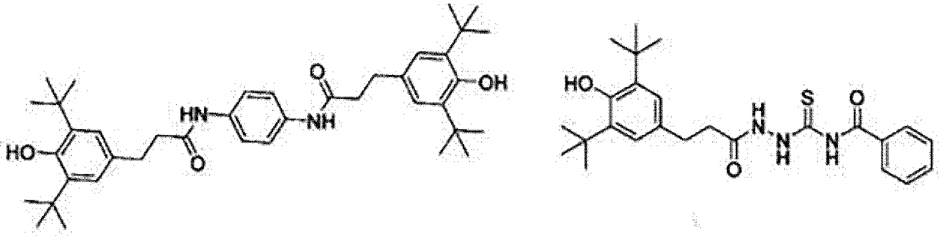

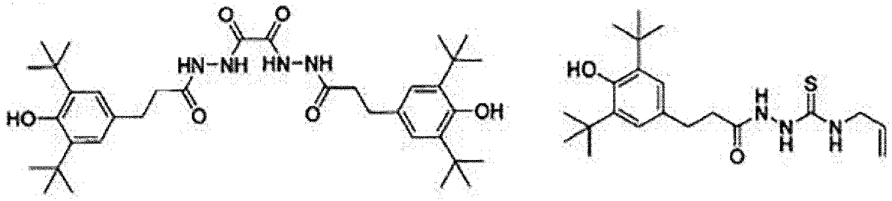

The content of the antioxidant is preferably from 0.1 parts by weight to 10 parts by weight, and more preferably from 0.5 parts by weight to 5 parts by weight with respect to 100 parts by weight of the polyimide. When the content of the antioxidant is less than 0.1 parts by weight, it is difficult to obtain the effect of improving elongation characteristics after reliability or adhesion to metal materials, and when the content is greater than 10 parts by weight, there is concern for causing a decrease in the sensitivity of the photosensitive resin composition due to interactions with a photosensitive agent.

The surfactant is a silicone-based surfactant or a fluorine-based surfactant, and specifically, BYK-077, BYK-085, BYK-300, BYK-301, BYK-302, BYK-306, BYK-307, BYK-310, BYK-320, BYK-322, BYK-323, BYK-325, BYK-330, BYK-331, BYK-333, BYK-335, BYK-341v344, BYK-345v346, BYK-348, BYK-354, BYK-355, BYK-356, BYK-358, BYK-361, BYK-370, BYK-371, BYK-375, BYK-380 and BYK-390 manufactured by BYK-Chemie GmbH, and the like, may be used as the silicone-based surfactant, and F-114, F-177, F-410, F-411, F-450, F-493, F-494, F-443, F-444, F-445, F-446, F-470, F-471, F-472SF, F-474, F-475, F-477, F-478, F-479, F-480SF, F-482, F-483, F-484, F-486, F-487, F-172D, MCF-350SF, TF-1025SF, TF-1117SF, TF-1026SF, TF-1128, TF-1127, TF-1129, TF-1126, TF-1130, TF-1116SF, TF-1131, TF1132, TF1027SF, TF-1441 and TF-1442 manufactured by DIC (DaiNippon Ink & Chemicals, Inc.), and the like, may be used as the fluorine-based surfactant, however, the surfactant is not limited thereto.

As the solvent, compounds known to enable formation of a photosensitive resin composition in the art may be used without particular limit. Nonlimiting examples of the solvent may include one or more types of compounds selected from the group consisting of esters, ethers, ketones, aromatic hydrocarbons and sulfoxides.

The ester-based solvent may include ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, gamma-butyrolactone, epsilon-caprolactone, delta-valerolactone, alkyl oxyacetate (example: methyl oxyacetate, ethyl oxyacetate, butyl oxyacetate (for example, methyl methoxyacetate, ethyl methoxyacetate, butyl methoxyacetate, methyl ethoxyacetate, ethyl ethoxyacetate and the like)), 3-oxypropionate alkyl esters (example: methyl 3-oxypropionate, ethyl 3-oxypropionate and the like (for example, methyl 3-methoxypropionate, ethyl 3-methoxypropionate, methyl 3-ethoxypropionate, ethyl 3-ethoxypropionate and the like)), 2-oxypropionate alkyl esters (example: methyl 2-oxypropionate, ethyl 2-oxypropionate, propyl 2-oxypropionate and the like (for example, methyl 2-methoxypropionate, ethyl 2-methoxypropionate, propyl 2-methoxypropionate, methyl 2-ethoxypropionate, ethyl 2-ethoxypropionate)), methyl 2-oxy-2-methylpropionate and ethyl 2-oxy-2-methylpropionate (for example, methyl 2-methoxy-2-methylpropionate, ethyl 2-ethoxy-2-methylpropionate and the like), methyl pyruvate, ethyl pyruvate, propyl pyruvate, methyl acetoacetate, ethyl acetoacetate, methyl 2-oxobutanoate, ethyl 2-oxobutanoate and the like.

The ether-based solvent may include diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, propylene glycol monopropyl ether acetate and the like.

The ketone-based solvent may include methyl ethyl ketone, cyclohexanone, cyclopentanone, 2-heptanone, 3-heptanone, N-methyl-2-pyrrolidone and the like.

The aromatic hydrocarbon-based solvent may include toluene, xylene, anisole, limonene and the like.

The sulfoxide-based solvent may include dimethyl sulfoxide and the like.

### [Insulating Film]

In addition, another embodiment of the present application provides an insulating film including the photosensitive resin composition or a cured product thereof.

The insulating film may include the photosensitive resin composition as it is.

The insulating film may include a cured product of the photosensitive resin composition.

Examples of a light source for curing the photosensitive resin composition according to one embodiment of the present disclosure may include a mercury vapor arc, a carbon arc, a Xe arc and the like, which emit light with a wavelength of 250 nm to 450 nm, but are not limited thereto.

After curing the photosensitive resin composition, the insulating film may further be subjected to heating treatment as necessary.

The heating treatment may be performed using a heating means such as a hot plate, a hot air circulation furnace, an infrared furnace or the like, and may be performed at a temperature of 180°C to 250°C, or 190°C to 220°C.

The insulating film exhibits excellent chemical resistance and mechanical properties, and may be preferably used as an insulating film of a semiconductor device, an interlayer insulating film for a rewiring layer, and the like. In addition, the insulation may be applied to a photoresist, an etching resist, a solder top resist and the like.

The insulating film may include a support or a substrate.

The support or the substrate is not particularly limited, and those known in the art may be used. For example, substrates for electronic components or those having a predetermined wiring pattern formed thereon may be included. Examples of the substrate may include a substrate made of metals such as silicon, silicon nitride, titanium, tantalum, palladium, titanium tungsten, copper, chromium, iron, aluminum, gold and nickel, a glass substrate or the like. Examples of the material for a wiring pattern may include copper, solder, chromium, aluminum, nickel, gold and the like, but are not limited thereto. The support or the substrate may preferably be a silicon wafer.

The coating method is not particularly limited, however, a spray method, a roll coating method, a spin coating method and the like may be used, and generally, a spin coating method is widely used. In addition, after forming the coating film, some of the residual solvent may be removed under reduced pressure in some cases.

In one embodiment of the present disclosure, the insulating film may have a thickness of 1 µm to 100 µm. When the thickness of the insulating film satisfies the above-mentioned range, an insulating film having excellent chemical resistance and mechanical properties targeted in the present application may be obtained. The thickness of the insulating film may be measured using a scanning electron microscope (SEM).

One embodiment of the present disclosure provides a semiconductor device including the insulating film.

The semiconductor device may be manufactured by further including various components commonly used in the art in addition to the insulating film.

### Mode for practicing the Invention

Hereinafter, the present disclosure will be described in detail with reference to examples in order to specifically describe the present disclosure. However, examples according to the present disclosure may be modified to various different forms, and the scope of the present disclosure is not construed as being limited to the examples described below. Examples of the present specification are provided in order to more fully describe the present disclosure to those having average knowledge in the art.

### Synthesis Examples 1 to 10 (Polyimide Resins A to J) and Comparative Synthesis Examples 1 to 7 (Polyimide Resins K to Q)

To a 1,000 mL round bottom flask as a reaction vessel, a diamine monomer that does not include a flexible functional group, a diamine monomer including a flexible functional group and 300 g of a PGMEA (propylene glycol methyl ether acetate) solvent were sequentially introduced, and after raising the temperature up to 120°C and completely dissolving the mixture by stirring, the flask was cooled to 80°C. An aromatic dianhydride monomer, an aliphatic dianhydride monomer, an end-capping monomer and 30 g of toluene were introduced together thereto, and the result was stirred at 150°C. After completely dissolving the reaction mixture, the flask was cooled to 50°C, and then 3 mmol of r-VL (gamma valerolactone) and 7 mmol of triethylamine (TEA) diluted in 10 g of propylene glycol monomethyl ether acetate (PGMEA) were introduced thereto. A dean-stark distillation apparatus was installed on the reaction vessel to remove water therethrough, and then the mixture was stirred for 18 hours at 175°C. After removing toluene introduced to the mixture solution, the solution was cooled to room temperature to collect a polymer. A weight average molecular weight (Mw) of the collected polymer was identified using gel permeation chromatography (GPC).

Types of the monomers used in synthesizing Polyimide Resins A to Q, the number of moles (mmol) of the introduced monomers, weight average molecular weights and polydispersity indices (PDI) of the collected polymers are shown in the following Table 1.

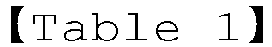

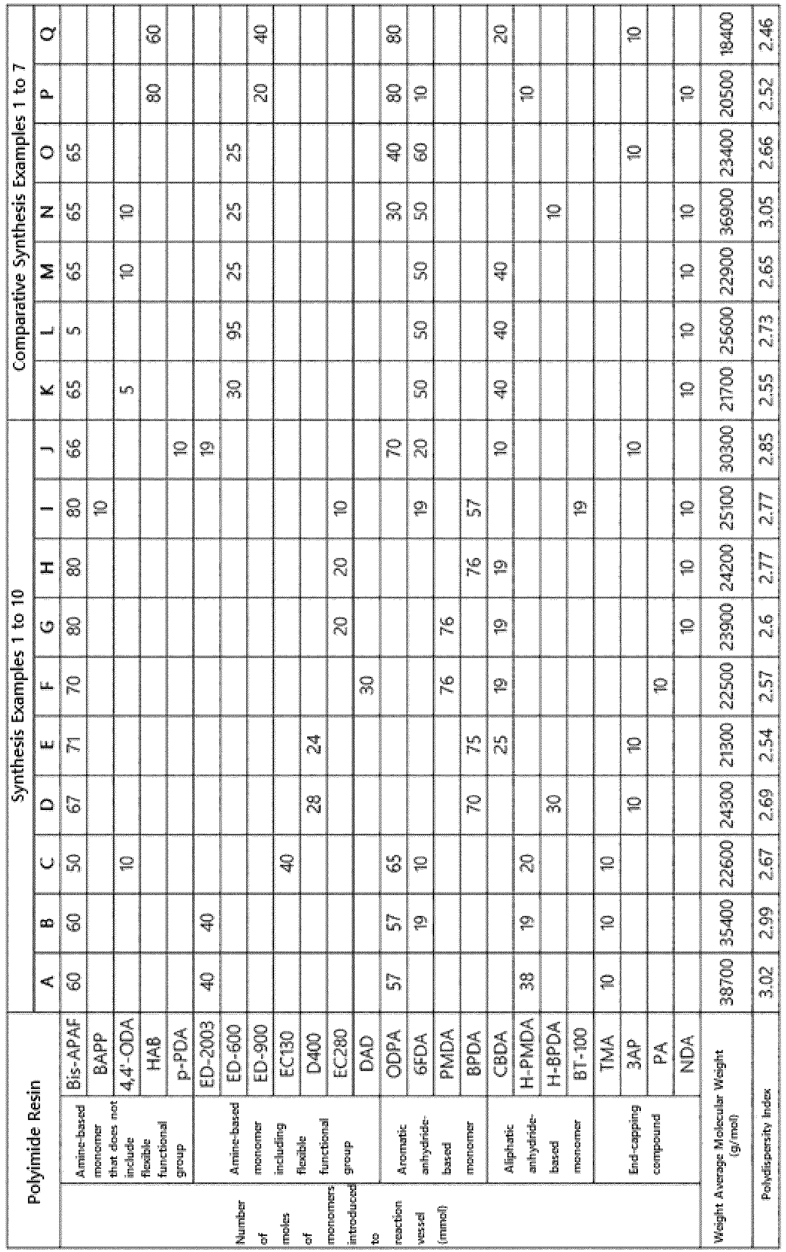

Abbreviations of the diamine monomers and the dianhydride monomers and detailed names of the products shown in Table 1 are as follows.

As the diamine monomer that does not include a flexible functional group, Bis-APAF is 2,2-bis(3-amino-4-hydroxyphenyl)hexafluoropropane, BAPP is 2,2-bis[4-(4-aminophenoxy)phenyl]propane, 4,4'-ODA is 4,4' -oxydianiline, HAB is 3,3'-dihydroxy-4,4'-diaminobiphenyl, and p-PDA is p-phenylenediamine.

As the diamine monomer including a flexible functional group, ED-2003, ED-900, ED-600 and D400 are Jeffamine^{®} products, EC130 and EC280 are Baxxodur^{®} products, and DAD is dodecane-1,12-diamine.

As the aromatic dianhydride monomer, ODPA is 4,4'-oxydiphthalic anhydride, 6FDA is 4,4'-(hexafluoroisopropylidene)diphthalic anhydride, PMDA is pyromellitic dianhydride, and BPDA is 3,3',4,4'-biphenyltetracarboxylic dianhydride.

As the aliphatic dianhydride monomer, CBDA is cyclobutane-1,2,3,4-tetracarboxylic dianhydride, H-PMDA is 1,2,4,5-cyclohexanetetracarboxylic dianhydride, H-BPDA is dicyclohexyl-3,4,3',4'-tetracarboxylic dianhydride, and BT-100 is 1,2,3,4-butane-tetracarboxylic dianhydride.

As the end-capping compound, TMA is trimellitic anhydride, 3AP is 3-aminophenol, PA is phthalic anhydride, and NDA is cis-5-Norbornene-endo-2,3-dicarboxylic anhydride.

### Photosensitive Resin Composition

Each of the polyimide resins of the synthesis examples and the comparative synthesis examples previously prepared, a curing agent, a photoactive compound, a surfactant and a solvent were mixed in the composition and the content described below, and then stirred for 24 hours to prepare a positive-type photosensitive resin composition.

### Example 1. Photosensitive Resin Composition A

23.8% of Polyimide Resin A of Synthesis Example 1, 5.00% of EXA-4850-1000 (DIC) as a bisphenol A-type epoxy resin, 1.45% of YDF-170 (Kukdo Chemical Co., Ltd.) as a bisphenol F-type epoxy resin, 0.70% of HMMM (hexamethoxymethylmelamine, TCI) as a methylol curing agent, 3.60% of TPD523 (Miwon Commercial Co., Ltd.) as a photosensitive material, 0.05% of R-40 (DIC) as a surfactant, 50.40% of PGMEA and 15.00% of GBL (gamma butyrolactone) were mixed, and then stirred for 24 hours to prepare a positive-type photosensitive resin composition. Each value indicates % by weight of each component based on 100% by weight of the whole resin composition.

### Examples 2 to 10 and Comparative Examples 1 to 7

In Examples 2 to 10, photosensitive resin compositions were prepared in the same manner as in Example 1, except that Polyimide Resins B to J were used instead of Polyimide Resin A. In Comparative Examples 1 to 7, photosensitive resin compositions were prepared in the same manner as in Example 1, except that Polyimide Resins K to Q were used instead of Polyimide Resin A.

### <Experimental Example>

### 1) Preparation of Sample for Measurement

The photosensitive resin composition prepared above was spin coated on a 6 inch wafer to form a film, and the solvent was evaporated and the film was initially cured for 2 minutes at 120°C. The film was finally cured for 2 hours at 180°C in an oven (INH oven manufactured by Koyo) under the nitrogen atmosphere, and the thickness of the film after final curing was 10 µm. In order to remove the cured film from the wafer, the film was immersed in 2.5% HF diluted in DI-water (deionized water) for 30 minutes, and when the film floated, the film was taken out and washed three times with DI-water. The obtained cured film was dried in a convection oven for 1 hour at 40°C, and then cut to a size of 10 cmx1 cm to prepare a sample for tensile measurement.

### 2) Measurements of Young's Modulus, Tensile Strength and Elongation

The prepared sample was loaded into a UTM (Universal Testing Machine, manufactured by ZwickRoell) at a temperature of 25°C, and then Young's modulus, tensile strength and elongation were measured. Herein, the measurement length of the sample was set to 5 cm, and the pulling speed was set to 10.0 mm/minute.

### 3) Measurements of Glass Transition Temperature (T_{g}) and Coefficient of Thermal Expansion (CTE)

Using Q400 equipment manufactured by TA Instruments, the sample prepared above was heated from a temperature of 25°C at a rate of 10°C/min under the nitrogen atmosphere to measure a glass transition temperature and a coefficient of thermal expansion.

### 4) Evaluation of Optimal Exposure Dose (Eₒₚ)

The photosensitive resin composition prepared above was spin coated on a 6-inch wafer, then soft baked (prebaked, SOB) for 2 minutes at 120°C, and then exposed from 200 mJ/cm² to 500 mJ/cm² at an interval of 10 mJ using an exposure machine. A resist pattern was prepared after development in a 2.38% aqueous TMAH (tetramethylammonium hydroxide) solution for 120 seconds at 23°C, and then Eₒₚ was identified using a SEM (scanning electron microscope).

**[Table 2]**

| | E_{op (}mJ / cm²₎ | Young' s Modulus (MPa) | Tensile Strength (MPa) | Elongation (%) | T_{g} (°C) | CTE (ppm/°C) |
|---|---|---|---|---|---|---|
| Example 1 | 320 | 2550 | 110 | 64 | 225 | 60 |
| Example 2 | 320 | 2500 | 105 | 60 | 221 | 58 |
| Example 3 | 340 | 2550 | 105 | 59 | 196 | 55 |
| Example 4 | 300 | 2600 | 100 | 55 | 210 | 57 |
| Example 5 | 300 | 2600 | 100 | 52 | 206 | 54 |
| Example 6 | 300 | 2600 | 105 | 54 | 210 | 55 |
| Example 7 | 280 | 2700 | 105 | 50 | 226 | 50 |
| Example 8 | 280 | 2650 | 105 | 52 | 224 | 47 |
| Example 9 | 260 | 2700 | 100 | 49 | 218 | 48 |
| Example 10 | 280 | 2700 | 100 | 47 | 210 | 45 |
| Comparative Example 1 | 240 | 2800 | 95 | 25 | 155 | 65 |
| Comparative Example 2 | Not Developed | 2300 | 80 | 18 | 102 | 120 |
| Comparative Example 3 | 240 | 2900 | 100 | 24 | 163 | 60 |
| Comparative Example 4 | 320 | 2950 | 100 | 27 | 170 | 64 |
| Comparative Example 5 | 340 | 2800 | 95 | 24 | 178 | 60 |
| Comparative Example 6 | 440 | 2750 | 100 | 42 | 207 | 51 |
| Comparative Example 7 | 650 | 2550 | 105 | 58 | 188 | 58 |

It can be seen that Examples 1 to 10, which are the photosensitive resin compositions according to the present disclosure in which the -F/-OH ratio included in the polyimide repeating unit satisfies greater than or equal to 2 and less than or equal to 5, have advantages of being readily soluble in PGMEA, an environmental-friendly aqueous solvent, and developable with TMAH, an aqueous developing solution, and at the same time, have excellent elongation, and excellent glass transition temperature as well. On the other hand, it can be seen that, in Comparative Example 2 having the -F/-OH ratio of 33, the composition was not developed with TMAH, an aqueous developing solution, and in Comparative Examples 1 to 5 having the -F/-OH ratio of greater than 5, elongation and glass transition temperature characteristics were inferior compared to those of Examples. In Comparative Examples 6 and 7 having the - F/-OH ratio of less than 2, Eₒₚ increased compared to in Examples, and accordingly, exposure energy required for pattern formation increased.

### 5) Measurement of Dielectric Constant

A dielectric constant was measured using PNA-L Network Analyzer N5230A (Agilent Technologies) and Split Post Dielectric Resonator (QWED) equipment. Specifically, a sample was prepared in a state of film having a size of 5 cmx5 cm or greater. 10 Ghz was set in the PNA-L Network Analyzer N5230A. A blank state was checked in the Split Post Dielectric Resonator. In the blank state, resonance frequency and Q value were measured. The sample was introduced to the SPD, and after inputting the thickness value, resonance frequency and Q value were measured. From this, a Dk/Df value was calculated.

### 6) Measurement of Chemical Resistance

A sample coated on a wafer was prepared. The thickness before chemical resistance evaluation was measured. A RDL stripper solution was heated on a 70°C hot plate. The sample was immersed in the RDL stripper solution and left therein for 1 minute. When the time is over, the sample was washed under running water. The thickness after chemical resistance evaluation was measured. After the measurements, a change in the thicknesses before and after the chemical resistance evaluation was calculated as %.

5% or less: ∘, 5% to 10%: △, 10% or greater: X

**[Table 3]**

| | Dk | Df | Chemical Resistance |
|---|---|---|---|
| Example 1 | 3.1999 | 0.0204 | ○ |
| Example 2 | 3.1907 | 0.0228 | ○ |
| Example 3 | 3.1850 | 0.0225 | ○ |
| Example 4 | 3.1966 | 0.0240 | ○ |
| Example 5 | 3.2105 | 0.0244 | ○ |
| Example 6 | 3.1919 | 0.0237 | ○ |
| Example 7 | 3.2060 | 0.0255 | ○ |
| Example 8 | 3.1949 | 0.0250 | ○ |
| Example 9 | 3.2080 | 0.0257 | ○ |
| Example 10 | 3.1990 | 0.0252 | ○ |
| Comparative Example 1 | 3.1856 | 0.0267 | Δ |
| Comparative Example 2 | 3.1531 | 0.0192 | X |
| Comparative Example 3 | 3.2005 | 0.0260 | Δ |
| Comparative Example 4 | 3.2019 | 0.0301 | ○ |
| Comparative Example 5 | 3.1994 | 0.0299 | ○ |
| Comparative Example 6 | 3.2009 | 0.0262 | Δ |
| Comparative Example 7 | 3.1956 | 0.0259 | X |

In Examples 1 to 10, which are the photosensitive resin compositions according to the present disclosure in which the - F/-OH ratio included in the polyimide repeating unit satisfies greater than or equal to 2 and less than or equal to 5, dielectric constant (Dk) and dielectric loss (D_{f}) were low, and chemical resistance characteristics were excellent as well.

On the other hand, Comparative Examples 1 to 5 having the - F/-OH ratio of greater than 5 had poor chemical resistance characteristics and high dielectric loss (D_{f}), and showed inferior performance as an insulating film compared to Example 1 to 10. Particularly, in Comparative Example 2 having the -F/-OH ratio of 33, chemical resistance was evaluated to be very poor. In addition, in Comparative Examples 6 and 7 having the -F/-OH ratio of less than 2, chemical resistance characteristics were poor, and dielectric loss (Df) was somewhat high as well.

Accordingly, since the polyimide repeating unit includes -F and -OH functional groups and the ratio of -F/-OH included in the repeating unit satisfies 2≤-F/-OH≤5, the photosensitive resin composition according to one embodiment of the present disclosure has advantages of being readily soluble in PGMEA, an environmental-friendly aqueous solvent, and developable with TMAH, an aqueous developing solution, and at the same time, has excellent properties such as dielectric loss (D_{f}) and elongation, and has excellent chemical resistance as well.

Hereinbefore, the present disclosure has been described with limited examples, however, the present disclosure is not limited thereto, and it is obvious that various changes and modifications may be made by those skilled in the art within technical ideas of the present disclosure and the range of equivalents of the claims to be described.

## Claims

1. A photosensitive resin composition comprising a polyimide including repeating units represented by the following Chemical Formulae 1 to 4,
wherein a ratio between a total number of -F functional groups and a total number of -OH functional groups included in the repeating units represented by Chemical Formulae 1 to 4 satisfies 2≤-F/-OH≤5: 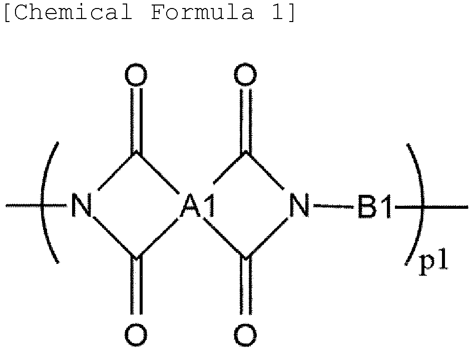 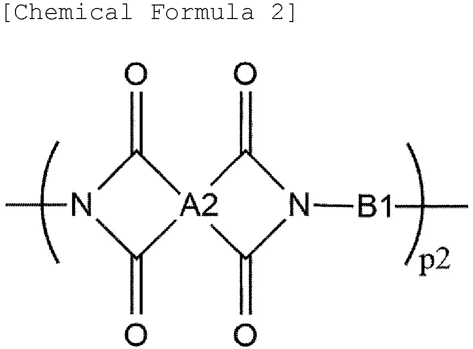 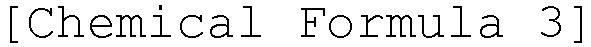 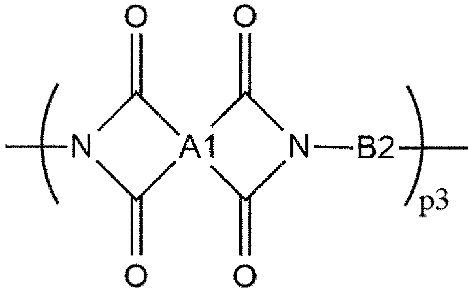 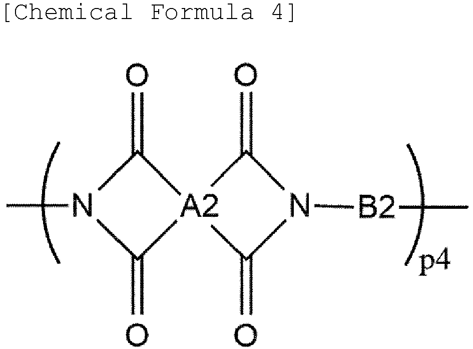 wherein in Chemical Formulae 1 to 4,
A1 is a tetravalent aliphatic organic group;
A2 is a tetravalent aromatic ring group;
B1 is a divalent aromatic ring group;
B2 is a flexible functional group;
p1 to p4 are each independently an integer of 1 to 10,000; and
at least one of A1, A2, B1 and B2 includes -F, -OH or -F and -OH functional groups.

2. The photosensitive resin composition of claim 1, wherein a ratio of a total number of the repeating units represented by Chemical Formulae 1 and 3 with respect to a total number of the repeating units represented by Chemical Formulae 2 and 4 satisfies 0.01 to 1.0.

3. The photosensitive resin composition of claim 1, wherein a ratio of a total number of the repeating units represented by Chemical Formulae 1 and 3 with respect to a total number of the repeating units represented by Chemical Formulae 1 to 4 satisfies 0.05 to 0.5.

4. The photosensitive resin composition of claim 1, wherein a ratio of a total number of the repeating units represented by Chemical Formulae 3 and 4 with respect to a total number of the repeating units represented by Chemical Formulae 1 to 4 satisfies 0.05 to 0.5.

5. The photosensitive resin composition of claim 1, wherein the tetravalent aliphatic organic group includes one or more types selected from among a substituted or unsubstituted tetravalent aliphatic ring group, the following Chemical Formula 5 and the following Chemical Formula 6: 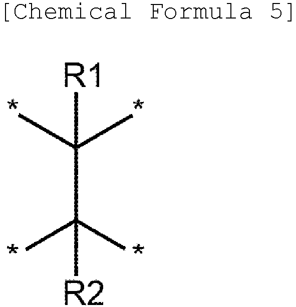 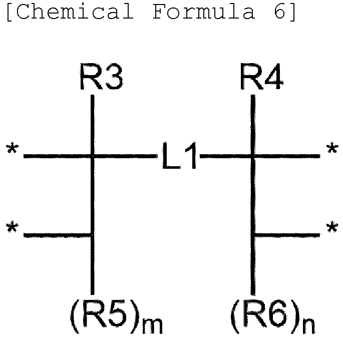 wherein in Chemical Formulae 5 and 6,
L1 is a direct bond; a substituted or unsubstituted alkylene group; -O-; -SO₂-; -CO-; or -OCO-;
R1 to R6 are the same as or different from each other, and each are independently hydrogen; a substituted or unsubstituted alkyl group; or a carboxyl group;
m and n are 2;
R5s are the same as or different from each other; and
R6s are the same as or different from each other.

6. The photosensitive resin composition of claim 1, wherein the tetravalent aliphatic organic group includes one or more types selected from among the following chemical formulae:

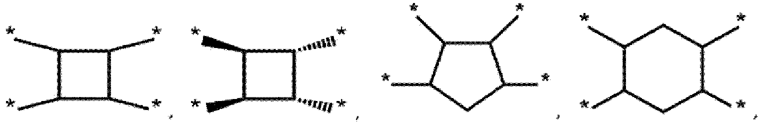

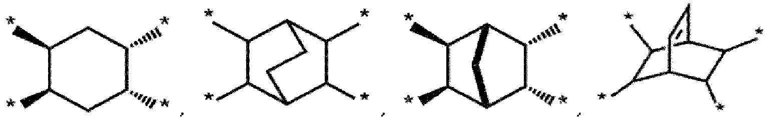

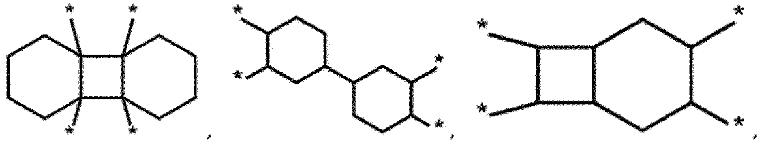

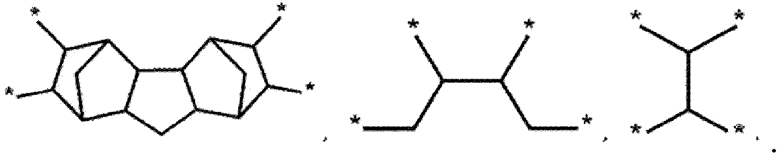

7. The photosensitive resin composition of claim 1, wherein the tetravalent aromatic ring group includes one or more types selected from among a substituted or unsubstituted tetravalent aromatic single ring and the following Chemical Formula 7: 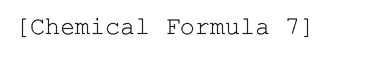 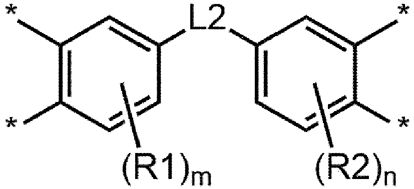 wherein in Chemical Formula 7,
L2 is a direct bond; a substituted or unsubstituted alkylene group; a substituted or unsubstituted arylene group; - O-; -SO₂-; -CO-; or -OCO-;
R1 and R2 are the same as or different from each other, and each independently hydrogen; a substituted or unsubstituted alkyl group; or a carboxyl group;
m and n are the same as or different from each other, and each independently an integer of 0 to 3;
when m is 2 or greater, R1s are the same as or different from each other; and
when n is 2 or greater, R2s are the same as or different from each other.

8. The photosensitive resin composition of claim 1, wherein the divalent aromatic ring group includes one or more types selected from among a substituted or unsubstituted divalent aromatic single ring, the following Chemical Formula 8 and the following Chemical Formula 9: 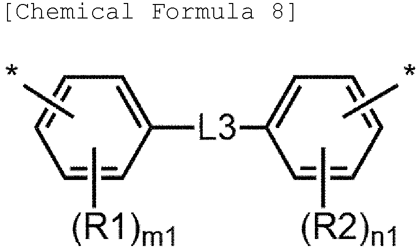 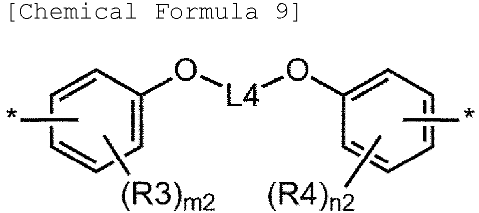 wherein in Chemical Formulae 8 and 9,
L3 and L4 are the same as or different from each other, and each are independently a direct bond; a substituted or unsubstituted alkylene group; a substituted or unsubstituted arylene group; -O-; -SO₂-; -CO-; or -OCO-;
R1 to R4 are the same as or different from each other, and each independently hydrogen; a substituted or unsubstituted alkyl group; a substituted or unsubstituted alkoxy group; a hydroxyl group; or a substituted or unsubstituted amine group;
m1, m2, n1 and n2 are the same as or different from each other, and are each independently an integer of 0 to 4;
when m1 is 2 or greater, R1s are the same as or different from each other;
when n1 is 2 or greater, R2s are the same as or different from each other;
when m2 is 2 or greater, R3s are the same as or different from each other; and
when n2 is 2 or greater, R4s are the same as or different from each other.

9. The photosensitive resin composition of claim 1, wherein the flexible functional group includes one or more types selected from among the following Chemical Formulae 10 to 13: 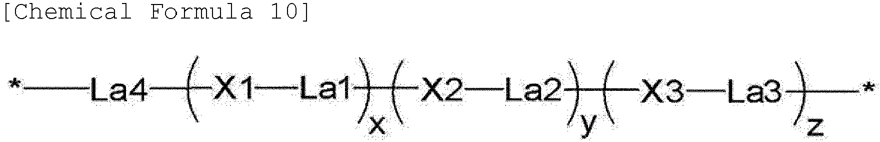 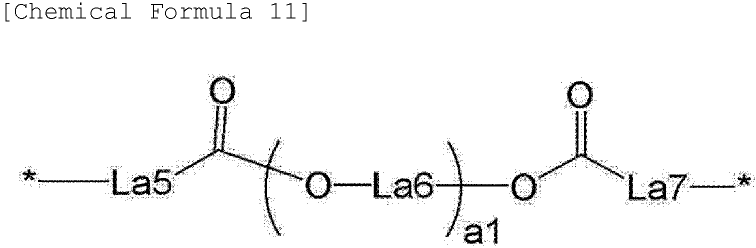 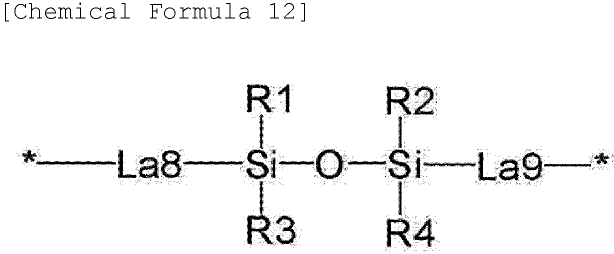 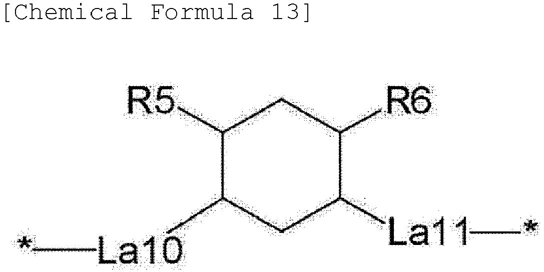 in Chemical Formulae 10 to 13,
X1 to X3 are the same as or different from each other, and each are independently -O-; or -CH₂-;
La1 to La11 are the same as or different from each other, and each are independently a substituted or unsubstituted alkylene group; or a substituted or unsubstituted arylene group;
R1 to R6 are the same as or different from each other, and each are independently hydrogen; or a substituted or unsubstituted alkyl group;
x, y and z are each independently a real number of 0 to 50; and
a1 is a real number of 1 to 30.

10. The photosensitive resin composition of claim 1, wherein the flexible functional group includes one or more types selected from among the following chemical formulae: 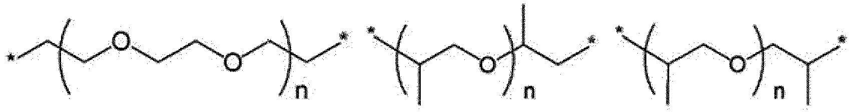 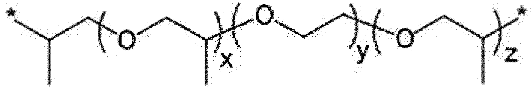 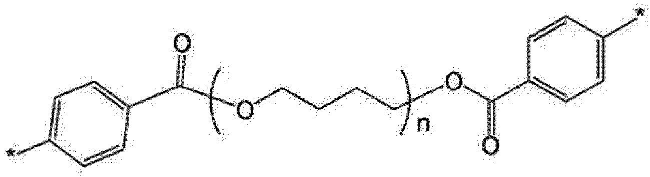 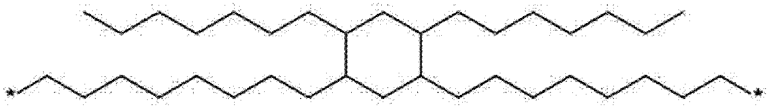 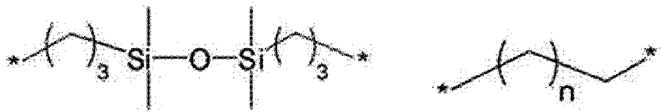 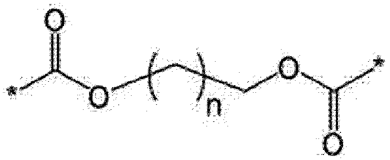 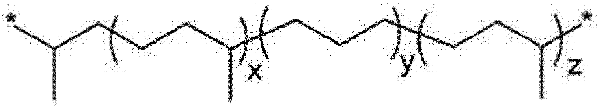 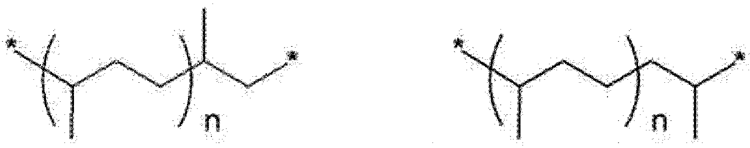 in the chemical formulae,
ns are each independently a real number of 1 to 30; and
x, y and z are each independently a real number of 1 to 50.

11. The photosensitive resin composition of claim 1, further comprising one or more types selected from among a photosensitive agent, a cross-linking agent, an antioxidant, a surfactant and a solvent.

12. An insulating film comprising the photosensitive resin composition of claim 1, or a cured product thereof.

13. A semiconductor device comprising the insulating film of claim 12.
